# EUROPEAN PATENT APPLICATION

(11) **EP 4 770 386 A1**
(43) Date of publication of application: **01.07.2026**
(21) Application number: 25857980.4
(22) Date of filing: 08.01.2025
(51) Int. Cl.: H10K 59/35, H10K 59/38

(54) **DISPLAY PANEL AND DISPLAY DEVICE**

(30) Priority: 27.09.2024 CN 202411369829
(71) Applicant: Wuhan Tianma Microelectronics Co., Ltd., Wuhan, Hubei 430205 (CN)
(72) Inventor: HUANG, Wei, Wuhan, Hubei 430205 (CN); MA, Yangzhao, Wuhan, Hubei 430205 (CN); YUE, Qin, Wuhan, Hubei 430205 (CN); GAO, You, Wuhan, Hubei 430205 (CN)
(74) Representative: Germain Maureau
(86) International application number: PCT/CN2025/071146
(87) International publication number: WO 2026/065846

(57) **Abstract**

Embodiments of the present disclosure provide a display panel and a display apparatus. The display panel includes a plurality of sub-pixels, wherein the sub-pixels include a first sub-pixel, a second sub-pixel, and a third sub-pixel having different colors from one another; two first sub-pixels and two second sub-pixels form a first virtual quadrilateral, the two first sub-pixels are positioned at a pair of opposite corners of the first virtual quadrilateral, the two second sub-pixels are positioned at the other pair of opposite corners of the first virtual quadrilateral, and one third sub-pixel is positioned inside the first virtual quadrilateral; four third sub-pixels form a second virtual quadrilateral, and one first sub-pixel or one second sub-pixel is positioned inside the second virtual quadrilateral; and at least one of the first sub-pixel, the second sub-pixel, and the third sub-pixel includes an irregularly-shaped sub-pixel, a shape contour of the irregularly-shaped sub-pixel includes a circular arc and an elliptical arc, and the circular arc and the elliptical arc are connected end to end. The present disclosure can reduce diffraction and mitigate the issue of unintended light emission in the sub-pixels.

## Description

The present application claims priority to Chinese Patent Application No. 202411369829.9, titled "DISPLAY PANEL AND DISPLAY APPARATUS", filed with the China National Intellectual Property Administration on September 27, 2024, the content of which is incorporated herein by reference in its entirety.

### TECHNICAL FIELD

The present disclosure relates to the field of display technologies, and in particular, to a display panel and a display apparatus.

### BACKGROUND

Organic Light-Emitting Diodes (OLEDs) have characteristics such as self-luminescence, low power consumption, high brightness, and fast response, thus attracting wide attention. Organic self-luminous display technology has become a focus of research in the current display field. To achieve full-color display of an OLED display panel, a plurality of sub-pixels with different light-emitting colors are arranged in the display panel, such as red sub-pixels (R), green sub-pixels (G), and blue sub-pixels (B). Under the demand for high-resolution displays, the three color sub-pixels need to be closely arranged. How to design the sub-pixels to enable the display panel to have better display performance is currently a research direction for those in the art.

### SUMMARY

Embodiments of the present disclosure provide a display panel and a display apparatus to address the technical issue of improving the display effect of the display panel.

In a first aspect, an embodiment of the present disclosure provides a display panel, including a plurality of sub-pixels, where the plurality of sub-pixels include a first sub-pixel, a second sub-pixel, and a third sub-pixel having colors different from one another;
two first sub-pixels and two second sub-pixels form a first virtual quadrilateral, the two first sub-pixels are positioned at a pair of opposite corners of the first virtual quadrilateral, the two second sub-pixels are positioned at the other pair of opposite corners of the first virtual quadrilateral, and one third sub-pixel is positioned inside the first virtual quadrilateral;
four third sub-pixels form a second virtual quadrilateral, and one first sub-pixel or one second sub-pixel is positioned inside the second virtual quadrilateral; and
where at least one of the first sub-pixel, the second sub-pixel, and the third sub-pixel includes an irregularly-shaped sub-pixel, a shape contour of the irregularly-shaped sub-pixel includes a circular arc and an elliptical arc, and the circular arc and the elliptical arc are connected end to end.

In a second aspect, based on the same inventive concept, an embodiment of the present disclosure further provides a display apparatus, including the display panel according to any one of the embodiments of the present disclosure.

The display panel and display apparatus according to the embodiments of the present disclosure have the following advantages: at least one of the three types of sub-pixels is configured as an irregularly-shaped sub-pixel, the shape contour of the irregularly-shaped sub-pixel is composed of a circular arc and an elliptical arc, and a position of a center of the irregularly-shaped sub-pixel varies according to its shape. The position of the center of the irregularly-shaped sub-pixel can be adjusted by designing the shape of the irregularly-shaped sub-pixel, thereby enabling the virtual quadrilateral on which it is located to have different shapes, without the need to move the position of the sub-pixel to meet the shape requirements of the virtual quadrilateral. The design using the irregularly-shaped sub-pixel can ensure that in the virtual quadrilateral on which it is located, the difference in distance between each irregularly-shaped sub-pixel and a sub-pixel adjacent thereto is small, and the distance between each irregularly-shaped sub-pixel and the sub-pixel adjacent thereto is relatively uniform, which can mitigate the issue of unintended light emission in the sub-pixels. Moreover, the light-emitting boundary of the irregularly-shaped sub-pixel composed of the circular arc and the elliptical arc is relatively smooth and free of straight edges, which is conducive to reducing diffraction.

### BRIEF DESCRIPTION OF DRAWINGS

To describe the technical solutions in the embodiments of the present disclosure or the prior art more clearly, the drawings required to be used in the description of the embodiments or the prior art will be briefly introduced below. Apparently, the drawings in the following description are some embodiments of the present disclosure, and for those of skill in the art, other drawings can also be obtained based on these drawings without creative efforts.
FIG. 1 is a schematic diagram of a display panel according to an embodiment of the present disclosure;
FIG. 2 is a schematic diagram of an irregularly-shaped sub-pixel in an embodiment of the present disclosure;
FIG. 3 is a schematic diagram of a display panel in the related art;
FIG. 4 is a schematic diagram of another display panel in the related art;
FIG. 5 is a schematic diagram of another irregularly-shaped sub-pixel according to an embodiment of the present disclosure;
FIG. 6 is a schematic diagram of another irregularly-shaped sub-pixel according to an embodiment of the present disclosure;
FIG. 7 is a schematic diagram of another irregularly-shaped sub-pixel according to an embodiment of the present disclosure;
FIG. 8 is a schematic diagram of another irregularly-shaped sub-pixel according to an embodiment of the present disclosure;
FIG. 9 is a schematic diagram of another irregularly-shaped sub-pixel according to an embodiment of the present disclosure;
FIG. 10 is a schematic diagram of another irregularly-shaped sub-pixel according to an embodiment of the present disclosure;
FIG. 11 is a schematic diagram of another irregularly-shaped sub-pixel according to an embodiment of the present disclosure;
FIG. 12 is a schematic diagram of another irregularly-shaped sub-pixel according to an embodiment of the present disclosure;
FIG. 13 is a schematic diagram of a film layer structure of a display panel according to an embodiment of the present disclosure;
FIG. 14 is a simplified schematic diagram of another display panel according to an embodiment of the present disclosure;
FIG. 15 is a simplified schematic diagram of another display panel according to an embodiment of the present disclosure;
FIG. 16 is a simplified schematic diagram of another display panel according to an embodiment of the present disclosure;
FIG. 17 is a schematic diagram of a center position of an irregularly-shaped sub-pixel in an embodiment of the present disclosure;
FIG. 18 is a schematic diagram of another display panel according to an embodiment of the present disclosure;
FIG. 19 is a schematic diagram of another display panel according to an embodiment of the present disclosure;
FIG. 20 is a schematic diagram of another display panel according to an embodiment of the present disclosure;
FIG. 21 is a schematic diagram of another display panel according to an embodiment of the present disclosure;
FIG. 22 is a schematic diagram of another display panel according to an embodiment of the present disclosure;
FIG. 23 is a schematic diagram of another display panel according to an embodiment of the present disclosure;
FIG. 24 is a schematic diagram of another display panel according to an embodiment of the present disclosure;
FIG. 25 is a schematic diagram of another display panel according to an embodiment of the present disclosure;
FIG. 26 is a simplified schematic diagram of another display panel according to an embodiment of the present disclosure;
FIG. 27 is a schematic diagram of another display panel according to an embodiment of the present disclosure;
FIG. 28 is a schematic diagram of another display panel according to an embodiment of the present disclosure;
FIG. 29 is a schematic diagram of another display panel according to an embodiment of the present disclosure;
FIG. 30 is a partial schematic diagram of another display panel according to an embodiment of the present disclosure;
FIG. 31 is a schematic diagram of another display panel according to an embodiment of the present disclosure;
FIG. 32 is a schematic diagram of another display panel according to an embodiment of the present disclosure;
FIG. 33 is a schematic diagram of another display panel according to an embodiment of the present disclosure;
FIG. 34 is a schematic diagram of another display panel according to an embodiment of the present disclosure; and
FIG. 35 is a schematic diagram of a display apparatus according to an embodiment of the present disclosure.

### DESCRIPTION OF EMBODIMENTS

To make the objectives, technical solutions and advantages of the embodiments of the present disclosure more clear, the technical solutions in the embodiments of the present disclosure will be described clearly and completely below in conjunction with the drawings in the embodiments of the present disclosure. Apparently, the described embodiments are a part of the embodiments of the present disclosure, rather than all the embodiments. Based on the embodiments of the present disclosure, all other embodiments obtained by those of ordinary skill in the art without creative efforts all fall within the protection scope of the present disclosure.

Without departing from the spirit or scope of the present disclosure, various modifications and variations can be made in the present disclosure, which is apparent to those of skill in the art. Therefore, the present disclosure is intended to cover the modifications and variations of the present disclosure that fall within the scope of the corresponding claims (the claimed technical solutions) and their equivalents. It should be noted that the implementations provided by the embodiments of the present disclosure can be combined with each other without contradiction.

The terms used in the embodiments of the present disclosure are only for the purpose of describing specific embodiments, and are not intended to limit the present disclosure. The singular forms "a", "said" and "the" used in the embodiments of the present disclosure and the appended claims are also intended to include the plural forms, unless the context clearly indicates otherwise.

In a display panel according to an embodiment of the present disclosure, at least one of a first sub-pixel, a second sub-pixel, and a third sub-pixel is configured as an irregularly-shaped sub-pixel, and a circular arc and an elliptical arc in a shape contour of the irregularly-shaped sub-pixel are connected end to end, whereby a facing distance between the irregularly-shaped sub-pixel and a sub-pixel adjacent thereto can be increased, thereby mitigating unintended light emission in the sub-pixels and enhancing the display effect of the display panel.

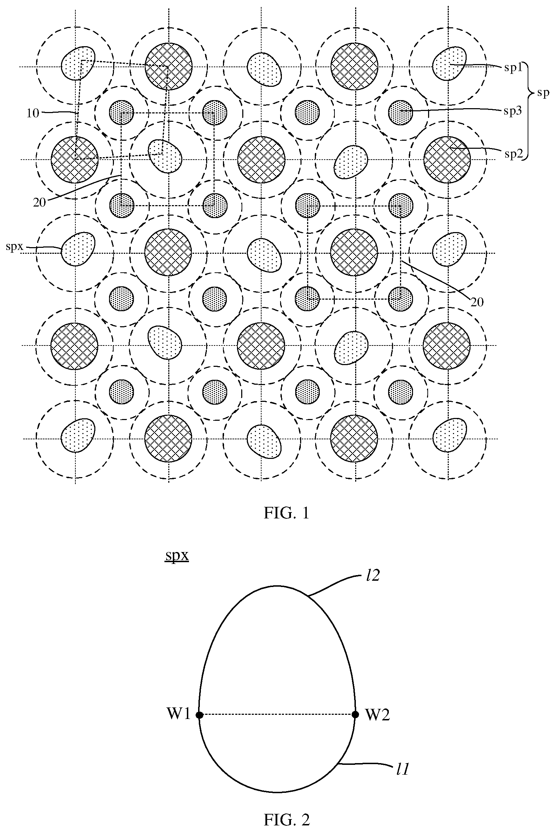

FIG. 1 is a schematic diagram of a display panel according to an embodiment of the present disclosure, and FIG. 2 is a schematic diagram of an irregularly-shaped sub-pixel in an embodiment of the present disclosure. As shown in FIG. 1, the display panel includes a plurality of sub-pixels sp, and the sub-pixels include a first sub-pixel sp1, a second sub-pixel sp2, and a third sub-pixel sp3 having colors different from one another. The first sub-pixel sp1, the second sub-pixel sp2, and the third sub-pixel sp3 each are a respective one of a red sub-pixel, a green sub-pixel, and a blue sub-pixel. Two first sub-pixels sp1 and two second sub-pixels sp2 form a first virtual quadrilateral 10. The two first sub-pixels sp1 are positioned at a pair of opposite corners of the first virtual quadrilateral 10, the two second sub-pixels sp2 are positioned at the other pair of opposite corners of the first virtual quadrilateral 10, and one third sub-pixel sp3 is positioned inside the first virtual quadrilateral 10. Four third sub-pixels sp3 form a second virtual quadrilateral 20, and one first sub-pixel sp1 or one second sub-pixel sp2 is positioned inside the second virtual quadrilateral 20. At least one of the first sub-pixel sp1, the second sub-pixel sp2, and the third sub-pixel sp3 includes an irregularly-shaped sub-pixel spx. The vertexes of each of the virtual quadrilaterals are the centers of the sub-pixels sp at the vertexes, respectively. In the embodiment of the present disclosure, the first virtual quadrilateral 10 may be an irregular quadrilateral, a parallelogram, or a square, and the second virtual quadrilateral 20 may be a parallelogram or a square.

In FIG. 1, the first sub-pixel sp1 is illustrated as the irregularly-shaped sub-pixel spx, and the second sub-pixel sp2 and the third sub-pixel sp3 are illustrated as circles. As can be seen in conjunction with FIG. 2, a shape contour of the irregularly-shaped sub-pixel spx includes a circular arc *l1* and an elliptical arc *l2,* and the circular arc *l1* and the elliptical arc *l2* are connected end to end. Two intersection points of the circular arc *l1* and the elliptical arc *l2* are a first intersection point W1 and a second intersection point W2. A length of the circular arc *l1* may be half the circumference of the circle to which it belongs, that is, the circular arc *l1* is a semicircular arc, or the length of the circular arc *l1* may be less than or greater than half the circumference of the circle to which it belongs. A length of the elliptical arc *l2* may be half the circumference of the ellipse to which it belongs, that is, the elliptical arc *l2* is a semielliptical arc, or the length of the elliptical arc *l2* may be less than or greater than half the circumference of the ellipse to which it belongs.

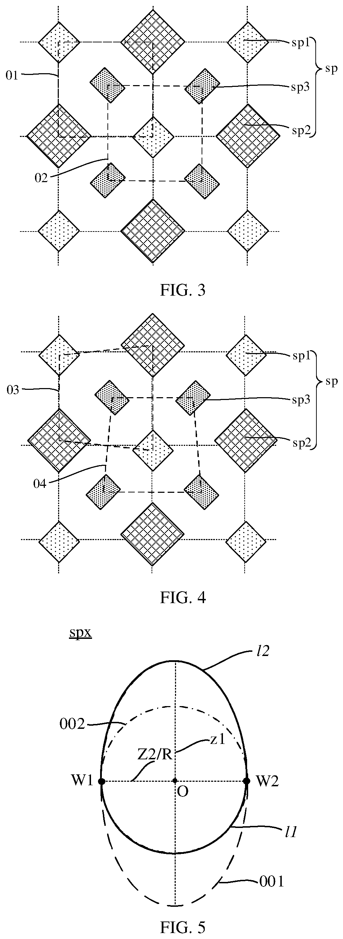

FIG. 3 is a schematic diagram of a display panel in the related art. In FIG. 3, each sub-pixel is rectangular for example, and the shape of each sub-pixel may also be circular. As shown in FIG. 3, two first sub-pixels sp1 and two second sub-pixels sp2 form a first virtual square 01. The two first sub-pixels sp1 are positioned at a pair of opposite corners of the first virtual square 01, the two second sub-pixels sp2 are positioned at the other pair of opposite corners of the first virtual square 01, and one third sub-pixel sp3 is positioned inside the first virtual square 01. Four third sub-pixels sp3 form a second virtual square 02.

FIG. 4 is a schematic diagram of another display panel in the related art. As shown in FIG. 4, two first sub-pixels sp1 and two second sub-pixels sp2 form a first virtual trapezoid 01. The two first sub-pixels sp1 are positioned at a pair of opposite corners of the first virtual trapezoid 03, the two second sub-pixels sp2 are positioned at the other pair of opposite corners of the first virtual trapezoid 03, and one third sub-pixel sp3 is positioned inside the first virtual trapezoid 03. Four third sub-pixels sp3 form a second virtual trapezoid 04. The pixel arrangement in FIG. 4 can be considered as being obtained by altering the pixel arrangement of FIG. 3. On the basis of the pixel arrangement shown in FIG. 3, the first virtual trapezoid 01 and the second virtual trapezoid 02 are formed by adjusting the positions of the sub-pixels. That is, virtual quadrilaterals of different shapes are constructed by moving the positions of the sub-pixels. As illustrated in FIG. 4, a distance between the first sub-pixel sp1 and the second sub-pixel sp2 at positions on the upper base of the first virtual trapezoid 01 is relatively small, which may cause the problem of unintended light emission in the sub-pixels.

In the embodiment of the present disclosure, at least one of the three types of sub-pixels is configured as an irregularly-shaped sub-pixel spx, the shape contour of the irregularly-shaped sub-pixel spx is composed of a circular arc *l1* and an elliptical arc *l2,* and a position of a center of the irregularly-shaped sub-pixel spx varies according to its shape. The position of the center of the irregularly-shaped sub-pixel spx can be adjusted by designing the shape of the irregularly-shaped sub-pixel spx, thereby enabling the virtual quadrilateral on which it is located to have different shapes, without the need to move the position of the sub-pixel to meet the shape requirements of the virtual quadrilateral. The design using the irregularly-shaped sub-pixel spx can ensure that in the virtual quadrilateral on which it is located, the difference in distance between each irregularly-shaped sub-pixel spx and a sub-pixel adjacent thereto is small, and the distance between each irregularly-shaped sub-pixel spx and a sub-pixel adjacent thereto is relatively uniform, which can mitigate the issue of unintended light emission in the sub-pixels. Moreover, in the embodiment of the present disclosure, the irregularly-shaped sub-pixel spz is composed of the circular arc *l1* and the elliptical arc *l2,* and its light-emitting boundary is relatively smooth and free of straight edges, which is conducive to reducing diffraction.

In addition, in some implementations, the area of the irregularly-shaped sub-pixel spx can be configured to be larger than the area of the virtual circle to which the circular arc *l1* belongs, which can increase the aperture ratio of the sub-pixel and improve the lifespan of the sub-pixel.

In some implementations, FIG. 5 is a schematic diagram of another irregularly-shaped sub-pixel according to an embodiment of the present disclosure. As shown in FIG. 5, an ellipse to which the elliptical arc *l2* belongs is a virtual ellipse 001, and a circle to which the circular arc *l1* belongs is a virtual circle 002; the virtual ellipse 001 has a major axis z1 and a minor axis z2. The circular arc *l1* intersects the major axis z1 of the virtual ellipse 001. This implementation can provide an irregularly-shaped sub-pixel spx with a relatively large area. For example, the area of the virtual ellipse 001 can be designed to be larger than the area of the virtual circle 002 to which the circular arc *l1* belongs, and the area of the irregularly-shaped sub-pixel spx is larger than the area of the virtual circle 002 to which the circular arc *l1* belongs, which can increase the aperture ratio of the sub-pixel and improve the lifespan of the sub-pixel.

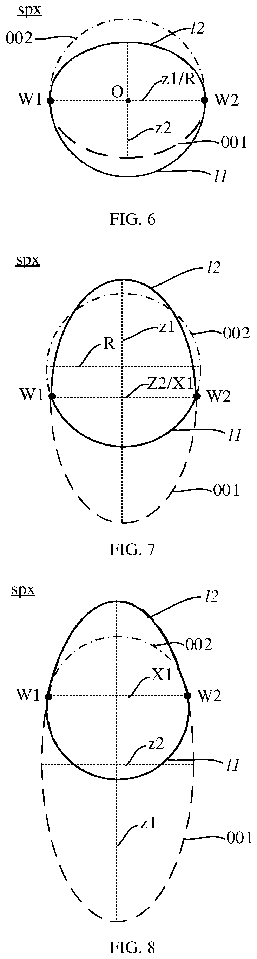

FIG. 6 is a schematic diagram of another irregularly-shaped sub-pixel according to an embodiment of the present disclosure. As shown in FIG. 6, an ellipse to which the elliptical arc *l2* belongs is a virtual ellipse 001, and a circle to which the circular arc *l1* belongs is a virtual circle 002, and the virtual ellipse 001 has a minor axis z2. The circular arc *l1* intersects an extension line of the minor axis z2 of the virtual ellipse 001. This implementation can provide an irregularly-shaped sub-pixel spx with a relatively small area. For example, the area of the virtual ellipse 001 can be designed to be smaller than the area of the virtual circle 002, and the area of the irregularly-shaped sub-pixel spx is smaller than the area of the virtual circle 002 to which the circular arc *l1* belongs. When the space within the display panel is limited, by reducing the size of the irregularly-shaped sub-pixel spx, the size of the sub-pixels of other colors can be correspondingly increased, which can increase the aperture ratio of the sub-pixels of other colors, thereby balancing the lifespan differences between sub-pixels of different colors.

As shown in FIG. 5, a diameter R of the virtual circle 002 is the minor axis z2 of the virtual ellipse 001. That is to say, the virtual circle 002 is an inscribed circle of the virtual ellipse 001. In this implementation, the irregularly-shaped sub-pixel spz formed by the circular arc *l1* and the elliptical arc *l2* has a relatively large area, which can increase the aperture ratio of the sub-pixel and improve the lifespan of the sub-pixel. Moreover, the connection transition between the circular arc *l1* and the elliptical arc *l2* is smooth, so that the boundary of the irregularly-shaped sub-pixel spz is relatively smooth, which can reduce diffraction and improve display effect in applications.

As shown in FIG. 6, the diameter R of the virtual circle 002 is the major axis z1 of the virtual ellipse 001. The virtual ellipse 001 may be regarded an inscribed ellipse of the virtual circle 002. In this embodiment, the irregularly-shaped sub-pixel spz formed by the circular arc *l1* and the elliptical arc *l2* has a relatively small area, which can leave more space for the sub-pixels of other colors within the entire display region, increase the size of the sub-pixels of other colors, and balance the lifespan differences of the sub-pixels of different colors. Furthermore, the connection between the circular arc *l1* and the elliptical arc *l2* transitions smoothly, making the boundary of the irregularly-shaped sub-pixel spz relatively smooth, which can reduce diffraction and improve display effect in application.

In some implementations, FIG. 7 is a schematic diagram of another irregularly-shaped sub-pixel according to an embodiment of the present disclosure. As shown in FIG. 7, an ellipse to which the elliptical arc 12 belongs is a virtual ellipse 001, and a circle to which the circular arc *l1* belongs is a virtual circle 002; and the virtual ellipse 001 has a major axis z1 and a minor axis z2. The circular arc *l1* intersects the major axis z1 of the virtual ellipse 001, and a connecting line between the first intersection point W1 and the second intersection point W1 is a first virtual line segment X1, where a length of the first virtual line segment X1 is smaller than a length of a diameter R of the virtual circle 002. In this implementation, a length of the circular arc *l1* is smaller than half the circumference of the virtual circle 002 to which it belongs. The area of a region enclosed by the first virtual line segment X1 and the circular arc *l1* is smaller than half the area of the virtual circle 002.

Optionally, as shown in FIG. 7, the first virtual line segment X1 coincides with the minor axis z2, and thus a length of the elliptical arc *l2* is equal to half the circumference of the virtual ellipse 001, and the elliptical arc *l2* is a semielliptical arc. The area of a region enclosed by the first virtual line segment X1 and the elliptical arc *l2* is equal to half the area of the virtual ellipse 001.

In some other implementations, FIG. 8 is a schematic diagram of another irregularly-shaped sub-pixel according to an embodiment of the present disclosure. As shown in FIG. 8, an ellipse to which the elliptical arc 12 belongs is a virtual ellipse 001, and a circle to which the circular arc 11 belongs is a virtual circle 002; and the virtual ellipse 001 has a major axis z1 and a minor axis z2. The circular arc *l1* intersects the major axis z1 of the virtual ellipse 001, and a connecting line between the first intersection point W1 and the second intersection point W1 is a first virtual line segment X1. A length of the first virtual line segment X1 is smaller than a length of the minor axis z2 of the virtual ellipse 001. In this implementation, a length of the elliptical arc *l2* is smaller than half the circumference of the virtual ellipse 001 to which it belongs. The area of a region enclosed by the first virtual line segment X1 and the elliptical arc 12 is smaller than half the area of the virtual ellipse 001.

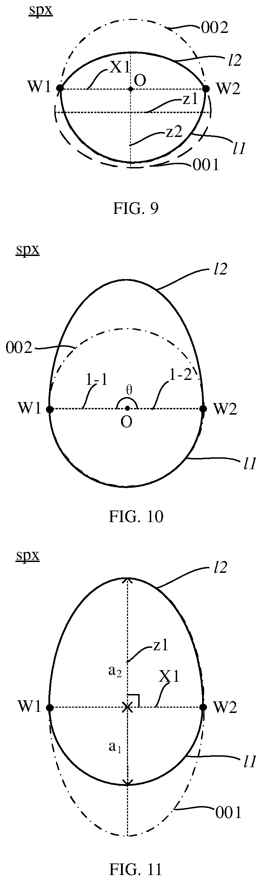

In some other implementations, FIG. 9 is a schematic diagram of another irregularly-shaped sub-pixel according to an embodiment of the present disclosure. As shown in FIG. 9, an ellipse to which the elliptical arc *l2* belongs is a virtual ellipse 001, and a circle to which the circular arc *l1* belongs is a virtual circle 002; and the virtual ellipse 001 has a major axis z1 and a minor axis z2. The circular arc *l1* intersects the minor axis z2 of the virtual ellipse 001, and a connecting line between the first intersection point W1 and the second intersection point W1 is a first virtual line segment X1. A length of the first virtual line segment X1 is smaller than that of the major axis z1 of the virtual ellipse 001. In this implementation, a length of the elliptical arc *l2* is smaller than half the circumference of the virtual ellipse 001 to which it belongs. The area of a region enclosed by the first virtual line segment X1 and the elliptical arc *l2* is smaller than half the area of the virtual ellipse 001.

In some implementations, as shown in FIG. 5 and FIG. 6, the ellipse to which the elliptical arc *l2* belongs is a virtual ellipse 001, and the circle to which the circular arc *l1* belongs is a virtual circle 002; and a connecting line between two intersection points (the first intersection point W1 and the second intersection point W2) of the circular arc *l1* and the elliptical arc *l2* passes through a circular center O of the virtual circle 002. In such irregularly-shaped sub-pixels spz, the connecting line between the first intersection point W1 and the second intersection point W2 is a first virtual line segment X1, and the first virtual line segment X1 is the diameter R of the virtual circle 002. The area of a region enclosed by the first virtual line segment X1 and the circular arc *l1* is equal to half the area of the virtual circle 002.

As also shown in FIG. 9, the connecting line between the two intersection points of the circular arc *l1* and the elliptical arc *l2* passes through a circular center O of the virtual circle 002. In the embodiment of FIG. 9, the area of a region enclosed by the first virtual line segment X1 and the circular arc *l1* is equal to half the area of the virtual circle 002.

In some implementations, FIG. 10 is a schematic diagram of another irregularly-shaped sub-pixel according to an embodiment of the present disclosure. As shown in FIG. 10, a circle to which the circular arc *l1* belongs is a virtual circle 002; and two intersection points of the circular arc *l1* and the elliptical arc *l2* are a first intersection point W1 and a second intersection point W2, a connecting line between the first intersection point W1 and a circular center O of the virtual circle 002 is a first connecting line 1-1, a connecting line between the second intersection point W2 and the circular center O of the virtual circle 002 is a second connecting line 1-2, and an angle θ between the first connecting line 1-1 and the second connecting line 1-2 is 180°. In this implementation, the first connecting line 1-1 and the second connecting line 1-2 are located on one straight line, and the straight line passes through the circular center O of the virtual circle 002, and thus a length of a connecting line between the first intersection point W1 and the second intersection point W2 is equal to a length of a diameter of the virtual circle 002. In the irregularly-shaped sub-pixel spz, the area of a region enclosed by the connecting line between the first intersection point W1 and the second intersection point W2 and the circular arc *l1* is half the area of the virtual circle 002.

In some implementations, FIG. 11 is a schematic diagram of another irregularly-shaped sub-pixel according to an embodiment of the present disclosure. As shown in FIG. 11, an ellipse to which the elliptical arc *l2* belongs is a virtual ellipse 001, two intersection points of the circular arc *l1* and the elliptical arc *l2* are a first intersection point W1 and a second intersection point W2, a connecting line between the first intersection point W1 and the second intersection point W2 is a first virtual line segment X1, and a major axis z1 of the virtual ellipse 001 is perpendicular to the first virtual line segment X1. The irregularly-shaped sub-pixel spz according to this implementation is symmetrical with respect to the major axis z1. The shape contour of the irregularly-shaped sub-pixel spz is an axially symmetrical pattern, and the shape of the irregularly-shaped sub-pixel spz is relatively regular. When the sub-pixels are arranged across the entire surface of the display panel, the irregularly-shaped sub-pixel spz can more easily cooperate with the sub-pixels of other colors, resulting in a more uniform and compact sub-pixel arrangement. When a sub-pixel rendering method is used for display, the display effect of the irregularly-shaped sub-pixel spz cooperating with other sub-pixels is better.

In an embodiment, the major axis z1 of the virtual ellipse 001 is perpendicular to the first virtual line segment X1, the first virtual line segment X1 coincides with a minor axis of the virtual ellipse 001, and the first virtual line segment X1 is the diameter of the virtual circle to which the circular arc *l1* belongs. In this embodiment, the area of a region enclosed by the first virtual line segment X1 and the elliptical arc *l2* is half the area of the virtual ellipse 001, the area of a region enclosed by the first virtual line segment X1 and the circular arc *l1* is half the area of the virtual circle, and the area of the irregularly-shaped sub-pixel spz is larger than the area of the virtual circle to which the circular arc *l1* belongs, thereby obtaining an irregularly-shaped sub-pixel spz with a relatively large area.

As shown in FIG. 11, a maximum distance between the circular arc *l1* and the first virtual line segment X1 is a₁, and a maximum distance between the elliptical arc *l2* and the first virtual line segment X1 is a₂, where a₁<a₂≤3*a₁. The irregularly-shaped sub-pixel spz is composed of a part of the ellipse and a part of the circle together, with the first virtual line segment X1 serving as a boundary dividing it into an elliptical portion and a circular portion. By setting a₁<a₂, along an extension direction of the major axis z1, a length of the elliptical portion is larger than a length of the circular portion. When a₁ is the radius of the virtual circle to which the circular arc *l1* belongs, this enables the area of the irregularly-shaped sub-pixel spz to be larger than the area of the virtual circle to which the circular arc *l1* belongs. Compared with circular sub-pixels, the size of the irregularly-shaped sub-pixel spz is larger, which can improve the aperture ratio of the sub-pixel. By setting a₂≤3*a₁, the difference in length between the elliptical portion and the circular portion along the extension direction of the major axis z1 is not too large, and the overall length of the irregularly-shaped sub-pixel spz is not too long. When the area of the irregularly-shaped sub-pixel spz meets the design requirements, it can more easily cooperate with other sub-pixels for arrangement, thereby ensuring a higher space utilization rate for the entire surface of the display panel.

In some implementations, 1.1≤a₂:a₁ ≤1.5.

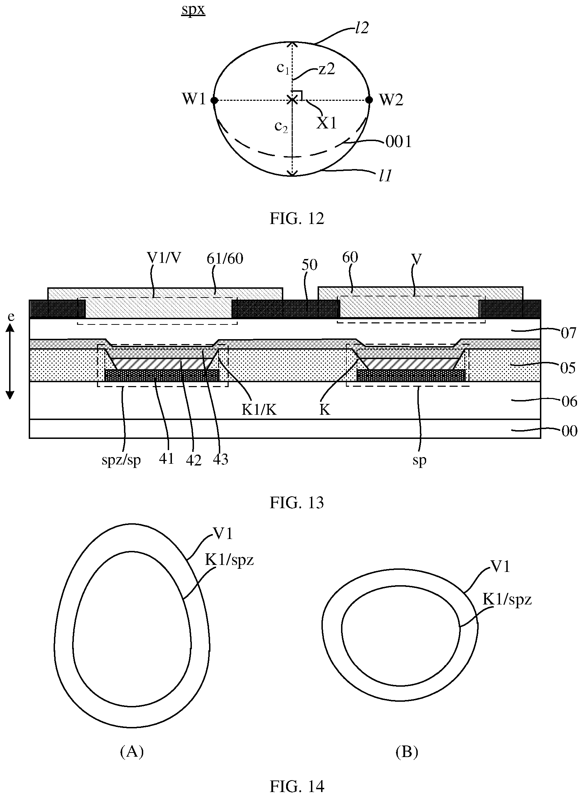

In some implementations, FIG. 12 is a schematic diagram of another irregularly-shaped sub-pixel according to an embodiment of the present disclosure. As shown in FIG. 12, an ellipse to which the elliptical arc *l2* belongs is a virtual ellipse 001, two intersection points of the circular arc *l1* and the elliptical arc *l2* are a first intersection point W1 and a second intersection point W2, a connecting line between the first intersection point W1 and the second intersection point W2 is a first virtual line segment X1, and a minor axis z2 of the virtual ellipse 001 is perpendicular to the first virtual line segment X1. The irregularly-shaped sub-pixel spz according to this embodiment is symmetrical with respect to the minor axis z2. The shape contour of the irregularly-shaped sub-pixel spz is an axially symmetrical pattern, and the shape of the irregularly-shaped sub-pixel spz is relatively regular. When the sub-pixels are arranged across the entire surface of the display panel, the irregularly-shaped sub-pixel spz can more easily cooperate with the sub-pixels of other colors, resulting in a more uniform and compact sub-pixel arrangement. When a sub-pixel rendering method is used for display, the display effect of the irregularly-shaped sub-pixel spz cooperating with other sub-pixels is better.

In an embodiment, the minor axis z2 of the virtual ellipse 001 is perpendicular to the first virtual line segment X1, the first virtual line segment X1 coincides with a major axis of the virtual ellipse 001, and the first virtual line segment X1 is the diameter of the virtual circle to which the circular arc *l1* belongs. In this embodiment, the area of a region enclosed by the first virtual line segment X1 and the elliptical arc *l2* is half the area of the virtual ellipse 001, the area of a region enclosed by the first virtual line segment X1 and the circular arc 11 is half the area of the virtual circle, and the area of the irregularly-shaped sub-pixel spz is larger than the area of the virtual ellipse 001.

As shown in FIG. 12, a maximum distance between the elliptical arc *l2* and the first virtual line segment X1 is c₁, and a maximum distance between the circular arc *l1* and the first virtual line segment X1 is c₂, where c₁ is less than c₂, and 0.5≤c₁/c₂≤0.9. The irregularly-shaped sub-pixel spz is composed of a part of the ellipse and a part of the circle together, with the first virtual line segment X1 serving as a boundary dividing it into an elliptical portion and a circular portion. By setting c₁ to be less than c₂, along an extension direction of the minor axis z2, a length of the circular portion is greater than a length of the elliptical portion. When c₂ is the radius of the virtual circle to which the circular arc *l1* belongs, this enables the area of the irregularly-shaped sub-pixel spz to be larger than the area of the virtual ellipse 001 and smaller than the area of the virtual circle to which the circular arc *l1* belongs. By setting c₁/c₂ within a certain range, the shape of the irregularly-shaped sub-pixel spz is not too flat, and the area of the irregularly-shaped sub-pixel spz is not too small, thereby ensuring a proper utilization of the overall space of the display panel.

In some implementations, FIG. 13 is a schematic diagram of a film layer structure of a display panel according to an embodiment of the present disclosure. As shown in FIG. 13, the display panel includes a substrate 00 and a pixel definition layer 05 positioned on one side of the substrate 00. The pixel definition layer 05 includes a plurality of openings K, and each sub-pixel sp includes one opening K. The sub-pixel sp includes a first electrode 41, a light-emitting layer 42, and a second electrode 43 that are stacked. Optionally, the first electrode 41 is an anode, and the second electrode 43 is a cathode. The opening K exposes the first electrode 41. The light-emitting layer 42 is deposited within the opening K. The second electrode 43 is positioned at the opening K and extends to one side of the pixel definition layer 05 away from the substrate 00. Adjacent second electrodes 32 are connected to each other to form a common electrode. A shape of the sub-pixel sp is the same as a shape of its corresponding opening K. The display panel includes a light-blocking structure 50 positioned on one side of the sub-pixel sp away from the substrate 00. The light-blocking structure 50 includes a plurality of hollows V. The display panel further includes a plurality of color light-filtering units 60. Each color light-filtering unit 60 is partially positioned within one hollow V and extends to one side of the light-blocking structure 50 away from the substrate 00. In the embodiment of the present disclosure, the light-blocking structure 50 and the color light-filtering units 60 are provided on the side of the sub-pixel sp away from the substrate 00. A structure formed by the light-blocking structure 50 and the color light-filtering units 60 together can reduce the reflectivity of the display panel to ambient light, thereby improving the display effect.

As shown in FIG. 13, the display panel includes a driving layer 06 positioned between the substrate 00 and the sub-pixel sp. A pixel circuit is provided in the driving layer 06, and is configured to drive the sub-pixel sp to emit light. An encapsulation layer 07 is further provided on the side of the sub-pixel sp away from the substrate 00. The encapsulation layer 07 is configured to isolate moisture and oxygen and ensure the service life of the sub-pixel sp.

As shown in FIG. 13, the openings K of the pixel definition layer 05 include a first opening K1, and the irregularly-shaped sub-pixel spx includes the first opening K1. The hollows V of the light-blocking structure 50 include a first hollow V1. Along a direction e perpendicular to the plane of the substrate 00, the first hollow V1 at least partially overlaps the irregularly-shaped sub-pixel spx.

FIG. 14 is a simplified schematic diagram of another display panel according to an embodiment of the present disclosure. FIG. 14 only illustrates the pattern shapes of the first opening K1 and the first hollow V1 at the region of the irregularly-shaped sub-pixel spx to describe the relationship between the pattern shapes. FIG. 14 is the simplified schematic diagram of a top view, and it can be understood that the shape of an orthographic projection of each structure onto the substrate is the same as its shape in the top view. Drawing (A) in FIG. 14 takes the shape of the irregularly-shaped sub-pixel spx illustrated in FIG. 11 as an example, and drawing (B) in FIG. 14 takes the shape of the irregularly-shaped sub-pixel spx illustrated in FIG. 12 as an example. As shown in FIG. 14, a shape of an orthographic projection of the first opening V1 onto the substrate is the same as the shape contour of the irregularly-shaped sub-pixel spx. A shape of an orthographic projection of the first hollow V1 onto the substrate is the same as the shape of the orthographic projection of the first opening K1 onto the substrate. In this embodiment, the shape of the first hollow V1 overlapping the irregularly-shaped sub-pixel spz is designed by adapting to the shape of the irregularly-shaped sub-pixel spz, thereby ensuring that a shape of a light-emitting area of the irregularly-shaped sub-pixel spz is the same as an originally designed shape. Moreover, the first opening K1 is positioned within the first hollow V1, that is, the area of the first hollow V1 is larger than the area of the first opening K1, thereby ensuring a light-emitting angle of the irregularly-shaped sub-pixel spz.

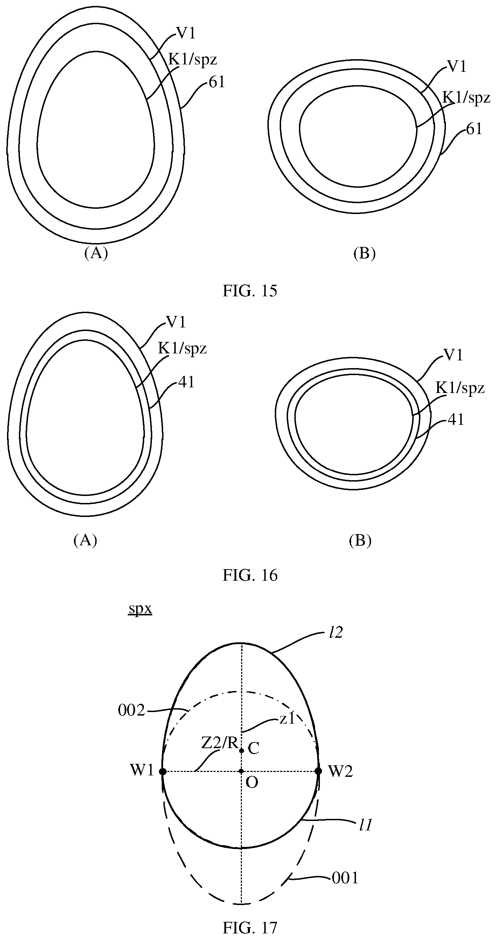

As shown in FIG.13, the color light-filtering units 60 include a first light-filtering unit 61. The first light-filtering unit 61 is partially positioned within the first hollow V1 and extends to the side of the light-blocking structure 50 away from the substrate 00. FIG. 15 is a simplified schematic diagram of another display panel according to an embodiment of the present disclosure. FIG. 15 only illustrates the pattern shapes of the first opening K1, the first hollow V1, and the color light-filtering unit at the region of the irregularly-shaped sub-pixel spx to describe the relationship between the pattern shapes. Drawing (A) in FIG.15 takes the shape of the irregularly-shaped sub-pixel spx illustrated in FIG. 11 as an example, and drawing (B) in FIG.15 takes the shape of the irregularly-shaped sub-pixel spx illustrated in FIG. 12 as an example. As shown in FIG. 15, a shape of an orthographic projection of the first light-filtering unit 61 onto the substrate is the same as a shape of an orthographic projection of the first opening K1 onto the substrate, and the area of the first light-filtering unit 61 is larger than the area of the first hollow V1. In this embodiment, the shape of the first light-filtering unit 61 is designed by adapting to the shape of the irregularly-shaped sub-pixel spx, so that the first light-filtering unit 61 can match the first hollow V1 of the light-blocking structure 50, thereby reducing the reflection of ambient light by the display panel by the first light-filtering unit 61 and the light-blocking structure 50 cooperating with each other.

As shown in FIG. 13, the openings K of the pixel definition layer 05 include a first opening K1, and the irregularly-shaped sub-pixel spx includes the first opening K1. The sub-pixel sp includes a first electrode 41, a light-emitting layer 42, and a second electrode 43 that are stacked. The first electrode 41 is positioned on one side of the second electrode 43 close to the substrate 00. FIG. 16 is a simplified schematic diagram of another display panel according to an embodiment of the present disclosure. FIG. 16 only illustrates the pattern shapes of the first opening K1, the first hollow V1, and the first electrode 41 at the region of the irregularly-shaped sub-pixel spx, to describe the relationship between the pattern shapes. Drawing (A) in FIG. 16 takes the irregularly-shaped sub-pixel spx illustrated in FIG. 11 as an example, and drawing (B) in FIG. 16 takes the irregularly-shaped sub-pixel spx illustrated in FIG. 12 as an example. As shown in FIG. 16, a shape of an orthographic projection of the first opening K1 onto the substrate is the same as the shape contour of the irregularly-shaped sub-pixel spx. In the irregularly-shaped sub-pixel spx, a shape of an orthographic projection of the first electrode 41 onto the substrate is the same as the shape of the orthographic projection of the first opening K1 onto the substrate. Moreover, in the irregularly-shaped sub-pixel spx, the area of the first opening K1 is larger than the area of the first electrode 41. In this embodiment, the shape of the first electrode 41 is designed according to the shape of the irregularly-shaped sub-pixel spx, which enables proper utilization of the space where the irregularly-shaped sub-pixel spx is located and ensures that the first electrodes 41 of different sub-pixels in the entire surface space of the display panel are mutually isolated and insulated.

In some implementations, the first sub-pixels sp1 or the second sub-pixels sp2 are irregularly-shaped sub-pixels spz. In some implementations, the third sub-pixels sp3 are irregularly-shaped sub-pixels spz. In some implementations, a subset of the first sub-pixels sp1 (or the second sub-pixels sp2) are irregularly-shaped sub-pixels spz, and a subset thereof of the first sub-pixels sp1 (or the second sub-pixels sp2) are conventional sub-pixels (such as circular or rectangular sub-pixels). As can be seen from the sub-pixel arrangement shown in FIG. 1, the positions of the first sub-pixel sp1 and the second sub-pixel sp2 can be interchanged. For example, one of the first sub-pixel sp1 and the second sub-pixel sp2 is a red sub-pixel while the other is a blue sub-pixel, and the third sub-pixel sp3 is a green sub-pixel. The following takes the first sub-pixel sp1 being the irregularly-shaped sub-pixel spz as an example for illustration and explanation, and for the case where the second sub-pixel sp2 is the irregularly-shaped sub-pixel spz, it can be understood by analogy.

In some embodiments of the present disclosure, when the sub-pixels form a virtual pattern, the centers of the sub-pixels serve as the vertexes of the virtual pattern. For a circular sub-pixel, its circular center serves as the center of the sub-pixel. For an irregularly-shaped sub-pixel spz, the center of gravity of its contour shape serves as the center. FIG. 17 is a schematic diagram of a center position of an irregularly-shaped sub-pixel in an embodiment of the present disclosure. As shown in FIG. 17, an ellipse to which the elliptical arc *l2* belongs is a virtual ellipse 001, and a circle to which the circular arc *l1* belongs is a virtual circle 002; the virtual ellipse 001 has a major axis z1 and a minor axis z2. A connecting line between a first intersection point W1 and a second intersection point W1 of the circular arc *l1* and the elliptical arc *l2* is a first virtual line segment X1, the first virtual line segment X1 coincides with the minor axis z2, the first virtual line segment X1 is perpendicular to the major axis z1, and the first virtual line segment X1 is a diameter of the virtual circle 002. In this embodiment, the center of gravity C of the irregularly-shaped sub-pixel spz is located on the major axis z1, and the center of gravity C is located on one side of the first virtual line segment X1 close to the elliptical arc *l2*.

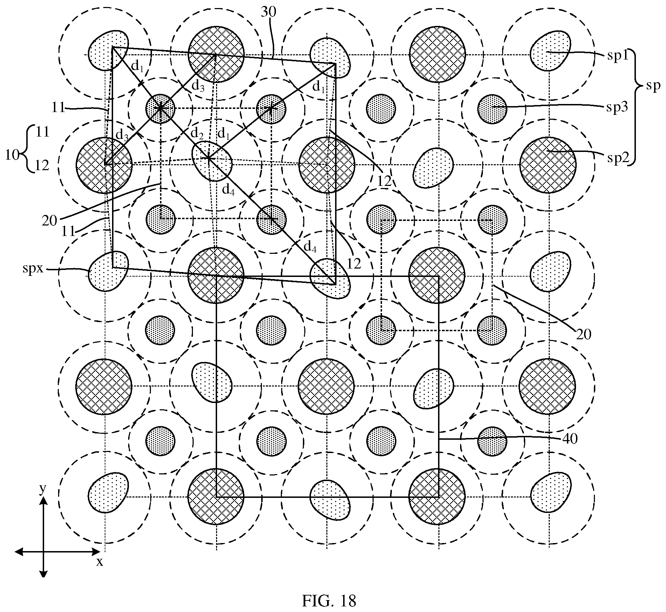

In some embodiments, FIG. 18 is a schematic diagram of another display panel according to an embodiment of the present disclosure. As shown in FIG. 18, the display panel includes a third virtual quadrilateral 30, and four first sub-pixels sp1 form the third virtual quadrilateral 30. One second virtual quadrilateral 20 is positioned inside the third virtual quadrilateral 30, and one first sub-pixel sp1 is positioned inside the second virtual quadrilateral 20. The four first sub-pixels sp1 forming the third virtual quadrilateral 30 are all irregularly-shaped sub-pixels spx. A direction from the circular arc *l1* to the elliptical arc *l2* in the irregularly-shaped sub-pixels spx is an elliptical-arc orientation. In the third virtual quadrilateral 30, the elliptical-arc orientations of two first sub-pixels sp1 positioned at opposite corners are perpendicular to each other.

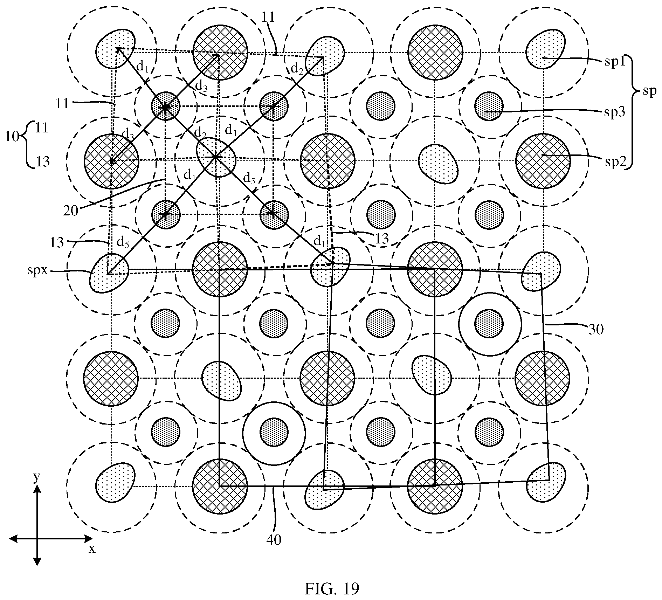

In some other embodiments, FIG. 19 is a schematic diagram of another display panel according to an embodiment of the present disclosure. As shown in FIG. 19, four first sub-pixels sp1 form a third virtual quadrilateral 30. One second virtual quadrilateral 20 is positioned inside the third virtual quadrilateral 30, and one first sub-pixel sp1 is positioned inside the second virtual quadrilateral 20. The four first sub-pixels sp1 forming the third virtual quadrilateral 30 are all irregularly-shaped sub-pixels spx. In the third virtual quadrilateral 30, the elliptical-arc orientations of two first sub-pixels sp1 positioned at opposite corners are parallel to each other. Optionally, as shown in FIG. 19, the elliptical-arc orientations of two first sub-pixels sp1 positioned at opposite corners are the same.

In the embodiments of the present disclosure, it is configured that four first sub-pixels sp1 form a third virtual quadrilateral 30, one first sub-pixel sp1 is positioned inside one third virtual quadrilateral 30, and the four first sub-pixels sp1 forming the third virtual quadrilateral 30 are irregularly-shaped sub-pixels spz. Since the shape contour of the irregularly-shaped sub-pixel spz is composed of the circular arc *l1* and the elliptical arc *l2,* the elliptical-arc orientation of the irregularly-shaped sub-pixel spz affects the center position of the irregularly-shaped sub-pixel spz. By configuring the elliptical-arc orientations of two first sub-pixels sp1 positioned at opposite corners of the third virtual quadrilateral 30 to be perpendicular to or parallel to each other, third virtual quadrilaterals 30 of different shapes can be formed. The third virtual quadrilateral 30 may be a parallelogram, an irregular quadrilateral, or a trapezoid. By designing the shape of the irregularly-shaped sub-pixel spx, the virtual quadrilateral on which it is positioned can have different shapes, without the need to move the position of the sub-pixel to meet the shape requirements of the virtual quadrilateral. The design using the irregularly-shaped sub-pixel spx can ensure that in the virtual quadrilateral on which it is located, the difference in distance between each irregularly-shaped sub-pixel spx and a sub-pixel adjacent thereto is small, and the distance between each irregularly-shaped sub-pixel spx and the sub-pixel adjacent thereto is relatively uniform, which can mitigate the issue of unintended light emission in the sub-pixels. Furthermore, by configuring the elliptical-arc orientations of two first sub-pixels sp1 positioned at opposite corners of the third virtual quadrilateral 30 to be perpendicular to or parallel to each other, the plurality of first sub-pixels sp1 across the entire surface of the display panel have different elliptical-arc orientations, which is conducive to mitigating color shift at display viewing angles and enhancing the wide-angle display effect.

In addition, both FIG. 18 and FIG. 19 illustrate that the first sub-pixel sp1 positioned inside the third virtual quadrilateral 30 is also the irregularly-shaped sub-pixel spx, that is, all the first sub-pixels sp1 are irregularly-shaped sub-pixels spx. In some implementations, the first sub-pixel sp1 inside the third virtual quadrilateral 30 is a regularly-shaped sub-pixel, that is, a subset of the first sub-pixels sp1 are irregularly-shaped sub-pixels spx and a subset of the first sub-pixels sp1 are regular sub-pixels, which are illustrated in the following relevant embodiments.

In some implementations, as shown in FIG. 18 or FIG. 19, four first sub-pixels sp1 form a third virtual quadrilateral 30; and one second virtual quadrilateral 20 is positioned inside the third virtual quadrilateral 30, and one first sub-pixel sp1 is positioned inside the second virtual quadrilateral 20. The four first sub-pixels sp1 forming the third virtual quadrilateral 30 are all irregularly-shaped sub-pixels spx. There are four first virtual quadrilaterals 10 at a position of the third virtual quadrilateral 30; in each of the four first virtual quadrilaterals 10, centers of the second sub-pixels are equidistant from a center of the third sub-pixel. When designing the sub-pixel arrangement, the distance between the first sub-pixel sp1 and the second sub-pixel sp2 can be finely adjusted by altering the elliptical-arc orientations of the first sub-pixels sp1, while maintaining the distance between the second sub-pixel sp2 and the third sub-pixel sp3, so that the distances between first sub-pixels sp1 and second sub-pixels sp2 are relatively uniform. For example, a fourth virtual quadrilateral 40 formed by the second sub-pixels sp2 can be configured to be a square, and one second virtual quadrilateral 20 is positioned inside the fourth virtual quadrilateral 40.

As shown in FIG. 18, on the third virtual quadrilateral 30, the elliptical-arc orientations of two adjacent first sub-pixels sp1 in a first direction x are different from each other, and the elliptical-arc orientations of two adjacent first sub-pixels sp1 in a second direction y are the same. The first direction x intersects the second direction y. As shown in FIG. 19, on the third virtual quadrilateral 30, the elliptical-arc orientations of two adjacent first sub-pixels sp1 in the first direction x are different from each other, and the elliptical-arc orientations of two adjacent first sub-pixels sp1 in the second direction y are different from each other. In the embodiments of FIG. 18 and FIG. 19, the elliptical-arc orientations of the first sub-pixels sp1 positioned at opposite corners of the third virtual quadrilateral 30, as well as the elliptical-arc orientations of the adjacent first sub-pixels sp1 in the first direction x or the second direction y, are designed, respectively, so that third virtual quadrilaterals 30 of different shapes can be formed. That is, by designing the shape of the irregularly-shaped sub-pixel spx, the virtual quadrilateral on which it is positioned can have different shapes, without the need to move the position of the sub-pixel to meet the shape requirements of the virtual quadrilateral. Furthermore, the plurality of first sub-pixels sp1 across the entire surface of the display panel are configured to have different elliptical-arc orientations, which is conducive to mitigating the color shift at display viewing angles and enhancing the wide-angle display effect.

Data lines and scan lines are arranged in the display panel, and pixel circuits are connected to the data lines and the scan lines. Optionally, the first direction x is a row direction, and the second direction y is a column direction. Typically, the first direction x and the second direction y are perpendicular to each other. The scan lines extend in the first direction x, and the data lines extend in the second direction y. Alternatively, the data lines extend in the first direction x, and the scan lines extend in the second direction y. Both the first direction x and the second direction y referred to in the following embodiments can be understood with reference to the description herein.

In an embodiment, in the embodiment of FIG. 18, the third virtual quadrilateral 30 is a parallelogram.

In an embodiment, in the embodiment of FIG. 19, the third virtual quadrilateral 30 is an irregular quadrilateral.

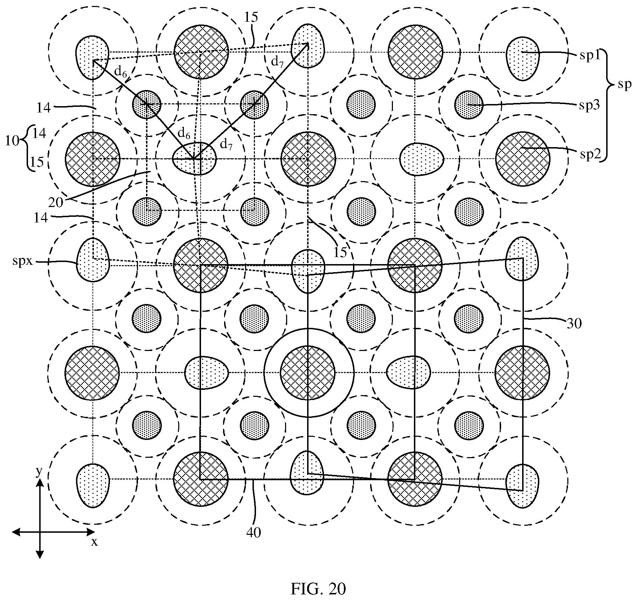

In another embodiment, FIG. 20 is a schematic diagram of another display panel according to an embodiment of the present disclosure. As shown in FIG. 20, four first sub-pixels sp1 form a third virtual quadrilateral 30; one second virtual quadrilateral 20 is positioned inside the third virtual quadrilateral 30, and one first sub-pixel sp1 is positioned inside the second virtual quadrilateral 20. The four first sub-pixels sp1 forming the third virtual quadrilateral 30 are all irregularly-shaped sub-pixels spx. In the third virtual quadrilateral 30, the elliptical-arc orientations of two first sub-pixels sp1 positioned at opposite corners are the same. Moreover, on the third virtual quadrilateral 30, the elliptical-arc orientations of two adjacent first sub-pixels sp1 in the first direction x are different from each other, and the elliptical-arc orientations of two adjacent first sub-pixels sp1 in the second direction y are opposite to each other. In this embodiment, the third virtual quadrilateral 30 is a trapezoid.

In some implementations, four first sub-pixels sp1 form a third virtual quadrilateral 30; and one second virtual quadrilateral 20 is positioned inside the third virtual quadrilateral 30, and one first sub-pixel sp1 is positioned inside the second virtual quadrilateral 20. The four first sub-pixels sp1 forming the third virtual quadrilateral 30 are all irregularly-shaped sub-pixels spx. As shown in FIG. 18, in the third virtual quadrilateral 30, the elliptical-arc orientations of two first sub-pixels sp1 positioned at opposite corners are perpendicular to each other. As shown in FIG. 19, in the third virtual quadrilateral 30, the elliptical-arc orientations of two first sub-pixels sp1 positioned at opposite corners are parallel to each other. In FIG. 18 and FIG. 19, the elliptical-arc orientations of the first sub-pixels sp1 positioned on the third virtual quadrilateral 30 have an acute angle with the first direction x. Optionally, the acute angle is 45°. In FIG. 20, the elliptical-arc orientations of the two first sub-pixels sp1 positioned at opposite corners of the third virtual quadrilateral 30 are parallel to each other, and the elliptical-arc orientations of the first sub-pixels sp1 positioned on the third virtual quadrilateral 30 are parallel to or perpendicular to the first direction x.

Taking the case where the first sub-pixels sp1 are placed in a positive orientation with the circular arc *l1* at the bottom and the elliptical arc *l2* at the top as an example, in FIG. 18 and FIG. 19, this is equivalent to arranging the first sub-pixels sp1 positioned on the third virtual quadrilateral 30 to be inclined relative to the first direction x. When the first direction x and the second direction y are perpendicular to each other, this also is equivalent to the irregularly-shaped sub-pixels spz being inclined relative to the second direction y. In the embodiment of FIG. 20, this is equivalent to placing the irregularly-shaped sub-pixels spz upright or inverted. In the embodiments of the present disclosure, by designing the placement mode of the irregularly-shaped sub-pixels spz, the shape of the first virtual quadrilateral 10 formed by the irregularly-shaped first sub-pixels sp1 and the second sub-pixels sp2 can have various shapes. For example, the shape can be a parallelogram, an irregular quadrilateral, or the like, which balances the differences in distance between the first sub-pixels sp1 and the sub-pixels of other colors, so that the distances are relatively uniform, and the issue of unintended light emission in the sub-pixels can be mitigated. Furthermore, configuring the plurality of first sub-pixels sp1 across the entire surface of the display panel to have different elliptical-arc orientations is conducive to mitigating the color shift at display viewing angles and enhancing the wide-angle display effect.

In some implementations, as shown in FIG. 18, FIG. 19, or FIG. 20, four first sub-pixels sp1 form a third virtual quadrilateral 30; and one second virtual quadrilateral 20 is positioned inside the third virtual quadrilateral 30, and one first sub-pixel sp1 is positioned inside the second virtual quadrilateral 20. The four first sub-pixels sp1 forming the third virtual quadrilateral 30 are all irregularly-shaped sub-pixels spx. The first sub-pixel sp1 inside the third virtual quadrilateral 30 is an irregularly-shaped sub-pixel spx, and the elliptical-arc orientation of the first sub-pixel sp1 is different from the elliptical-arc orientations of the first sub-pixels sp1 positioned on the third virtual quadrilateral 30. In this embodiment, all first sub-pixels sp1 in the display panel are configured to be irregularly-shaped sub-pixels spx, and the elliptical-arc orientations of the irregularly-shaped sub-pixels spx are configured to be diverse, so that the elliptical-arc orientations of adjacent irregularly-shaped sub-pixels spx are different from each other. The first sub-pixels sp1 are more uniformly distributed across the entire display region of the display panel. When a sub-pixel rendering method is used for display, the difference in display effects of the pixels including the first sub-pixels sp1 is small, and the overall display effect is better.

As shown in FIG. 18, FIG. 19, or FIG. 20, the elliptical-arc orientation of the first sub-pixel sp1 positioned inside the third virtual quadrilateral 30 is perpendicular to the elliptical-arc orientation of at least one of the four first sub-pixels sp1 forming the third virtual quadrilateral 30. Such a configuration enables the first sub-pixel sp1 positioned inside the third virtual quadrilateral 30 to form another third virtual quadrilateral 30 with three other first sub-pixels sp1, and the shapes of the two types of third virtual quadrilaterals 30 can be the same. When the display panel according to this embodiment adopts a sub-pixel rendering method for display, the difference in display effects of the pixels including the first sub-pixels sp1 is small, and the overall display effect is better. Furthermore, configuring the plurality of first sub-pixels sp1 across the entire surface of the display panel to have different elliptical-arc orientations is conducive to mitigating the color shift at display viewing angles and enhancing the wide-angle display effect.

In some implementations, as shown in FIG. 18 and FIG. 19, the elliptical-arc orientation of the first sub-pixel sp1 positioned on the third virtual quadrilateral 30 forms an acute angle with the first direction x; there are four first virtual quadrilaterals 10 at the position of the third virtual quadrilateral 30; and the four first virtual quadrilaterals 10 include at least one first virtual sub-quadrilateral 11. In the first virtual sub-quadrilateral 11: the centers of the two first sub-pixels sp1 are non-equidistant from the center of the third sub-pixel sp3, and the centers of the two second sub-pixels sp2 are equidistant from the center of the third sub-pixel sp3. By configuring the elliptical-arc orientations of the first sub-pixels sp1, the differences in distance between each of the two first sub-pixels sp1 and its respective second sub-pixel sp2 in the first virtual sub-quadrilateral 11 can be balanced, which can mitigate the issue of unintended light emission caused by the short distance between the first sub-pixel sp1 and the second sub-pixel sp2.

As shown in FIG. 18 and FIG. 19, in the first virtual sub-quadrilateral 11, the distance between the center of one first sub-pixel sp1 and the center of the third sub-pixel sp3 is d₁, the distance between the center of the other first sub-pixel sp1 and the center of the third sub-pixel sp3 is d₂, and the distance between the center of each of the two second sub-pixels sp2 and the center of the third sub-pixel sp3 is d₃, where d₁>d₃>d₂. In this embodiment, since the elliptical-arc orientations of the first sub-pixels sp1 at the opposite corners of the first virtual sub-quadrilateral 11 are perpendicular to each other, the first virtual sub-quadrilateral 11 can be formed as an irregular quadrilateral. Therefore, the distances between the first sub-pixels sp1 and the adjacent second sub-pixels sp2 in the first virtual sub-quadrilateral 11 can be relatively uniform, which is conducive to mitigating the issue of unintended light emission in the sub-pixels.

In some implementations, as shown in FIG. 18, the first sub-pixels sp1 are irregularly-shaped sub-pixels spz, the second virtual quadrilateral 20 formed by four third sub-pixels sp3 is a square, the fourth virtual quadrilateral 40 formed by four second sub-pixels sp2 is a square, and one second virtual quadrilateral 20 is positioned inside the fourth virtual quadrilateral 40. The third sub-pixel sp3 is a green sub-pixel, and one of the first sub-pixel sp1 and the second sub-pixel sp2 is a red sub-pixel, and the other is a blue sub-pixel. Since the second virtual quadrilateral 20 formed by the four third sub-pixels sp3 is a square, the green sub-pixels are substantially located on the same straight line in the row direction, and are also substantially located on the same straight line in the column direction, and the green sub-pixels are relatively uniformly distributed in both the row direction and the column direction. When a sub-pixel rendering method is used for display, the display effect of straight lines in the horizontal and vertical directions is better. Furthermore, since the fourth virtual quadrilateral 40 formed by the four second sub-pixels sp2 is a square, the second sub-pixels sp2 are substantially located on the same straight line in the row direction, and are also substantially located on the same straight line in the column direction, and the second sub-pixels sp2 are relatively uniformly distributed in both the row direction and the column direction. On this basis, by adjusting the elliptical-arc orientations of the irregularly-shaped sub-pixels spz, the first virtual quadrilateral 10 can have different shapes, and thus it is easier to achieve relatively uniform distances between the first sub-pixels sp1 and the adjacent second sub-pixels sp2, thereby achieving the technical effect of mitigating the unintended light emission in the sub-pixels.

As shown in FIG. 18, on the third virtual quadrilateral 30, the elliptical-arc orientations of two adjacent first sub-pixels sp1 in the second direction y are the same. The first virtual quadrilateral 10 further includes a second virtual sub-quadrilateral 12. In the second virtual sub-quadrilateral 12, the centers of the two first sub-pixels sp1 are equidistance from the center of the third sub-pixel sp3, and the centers of the two second sub-pixels sp2 are equidistant from the center of the third sub-pixel sp3. The second virtual sub-quadrilateral 12 may be a parallelogram, which achieves relatively uniform distances between the first sub-pixels sp1 and the adjacent second sub-pixels sp2, which is conducive to mitigating the issue of unintended light emission in the sub-pixels.

In some implementations, as shown in FIG. 18, there are two first virtual sub-quadrilaterals 11 and two second virtual sub-quadrilaterals 12 at the position of the third virtual quadrilateral 30. The two first virtual sub-quadrilaterals 11 are adjacent to each other in the second direction y and share a virtual edge, and the two second virtual sub-quadrilaterals 12 are adjacent to each other in the second direction y and share a virtual edge. In the embodiment of FIG. 18, the first sub-pixel sp1 positioned inside the third virtual quadrilateral 30 is an irregularly-shaped sub-pixel spz, and the elliptical-arc orientation of the first sub-pixel sp1 positioned inside the third virtual quadrilateral 30 is different from the elliptical-arc orientations of the first sub-pixels sp1 positioned at the vertexes of the third virtual quadrilateral 30. This results in the formation of the two first virtual sub-quadrilaterals 11, and the two second virtual sub-quadrilaterals 12 of different sizes at the position of the third virtual quadrilateral 30. Where in one second virtual sub-quadrilateral 12, the distance between the center of the first sub-pixel sp1 and the center of the third sub-pixel sp3 is d₁; and in the other second virtual sub-quadrilateral 12, the distance between the center of the first sub-pixel sp1 and the center of the third sub-pixel sp3 is d₄, where d₄>d₁. In the embodiment of the present disclosure, by configuring the elliptical-arc orientations of the first sub-pixels sp1, the two first virtual sub-quadrilaterals 11 and the two second virtual sub-quadrilaterals 12 can be formed at the position of the third virtual quadrilateral 30, and the sizes of the two second virtual sub-quadrilaterals 12 are different from each other. Through cooperation, the distances between the first sub-pixels sp1 and the adjacent second sub-pixels sp2 can be relatively uniform, which is conducive to mitigating the issue of unintended light emission in the sub-pixels.

As shown in FIG.18, in the two second virtual sub-quadrilaterals 12 at the position of the third virtual quadrilateral 30, the elliptical-arc orientations of the two first sub-pixels sp1 positioned at opposite corners of each second virtual sub-quadrilateral 12 are opposite to each other, and the second virtual sub-quadrilaterals 12 can be formed as parallelograms.

In some implementations, as shown in FIG. 18, the first sub-pixels sp1 are irregularly-shaped sub-pixels spz, four first sub-pixels sp1 form a third virtual quadrilateral 30, the third virtual quadrilateral 30 is a parallelogram, and the second virtual quadrilateral 20 inside the third virtual quadrilateral 30 is a square; and in the four first virtual quadrilaterals 10 at the position of the third virtual quadrilateral 30: two first virtual quadrilaterals 10 are irregular quadrilaterals, and the other two first virtual quadrilaterals 10 are parallelograms. Neither the first virtual sub-quadrilaterals 11 nor the second virtual sub-quadrilaterals 12 are trapezoids, achieving relatively uniform distances between the first sub-pixels sp1 and the adjacent second sub-pixels sp2, which is conducive to mitigating the issue of unintended light emission in the sub-pixels. In a solution where the third sub-pixel sp3 is a green sub-pixel, one of the first sub-pixel sp1 and the second sub-pixel sp2 is a red sub-pixel and the other is a blue sub-pixel, by configuring the second virtual quadrilateral 20 formed by four third sub-pixels sp3 to be a square, green sub-pixels are substantially located on the same straight line in the row direction, and are also substantially located on the same straight line in the column direction, and the green sub-pixels are relatively uniformly distributed in both the row direction and the column direction. When a sub-pixel rendering method is used for display, the display effect of straight lines in the horizontal and vertical directions is better. Furthermore, the fourth virtual quadrilateral 40 formed by the four second sub-pixels sp2 is a square, and one second virtual quadrilateral 20 is positioned inside the fourth virtual quadrilateral 40. The second sub-pixels sp2 are substantially located on the same straight line in the row direction, and are also substantially located on the same straight line in the column direction, and the second sub-pixels sp2 are relatively uniformly distributed in both the row direction and the column direction. On this basis, by adjusting the elliptical-arc orientations of the irregularly-shaped sub-pixels spz, the first virtual quadrilateral 10 can have different shapes, and thus it is easier to achieve relatively uniform distances between the first sub-pixels sp1 and the adjacent second sub-pixels sp2, thereby achieving the technical effect of mitigating the unintended light emission in the sub-pixels.

In some implementations, as shown in FIG. 19, on the third virtual quadrilateral 30, the elliptical-arc orientations of two adjacent first sub-pixels sp1 in the second direction y are different from each other. The first sub-pixel sp1 positioned inside the third virtual quadrilateral 30 is an irregularly-shaped sub-pixel spz, and the elliptical-arc orientation of the first sub-pixel sp1 positioned inside the third virtual quadrilateral 30 is different from the elliptical-arc orientations of the first sub-pixels sp1 positioned at the vertexes of the third virtual quadrilateral 30. The first virtual quadrilateral 10 further includes a third virtual sub-quadrilateral 13. In the third virtual sub-quadrilateral 13, the distance between the center of one first sub-pixel sp1 and the center of the third sub-pixel sp3 is d₁, and the distance between the center of the other first sub-pixel sp1 and the center of the third sub-pixel sp3 is d₅, where d₅>d₁. The centers of the two second sub-pixels sp2 are equidistant from the center of the third sub-pixel sp3. In this embodiment, by configuring the elliptical-arc orientations of the first sub-pixels sp1 at the opposite corners of the third virtual sub-quadrilateral 13, the third virtual sub-quadrilateral 13 can be formed as an irregular quadrilateral, which achieves relatively uniform distances between the first sub-pixels sp1 and the adjacent second sub-pixels sp2 on the third virtual sub-quadrilateral 13, which is conducive to mitigating the issue of unintended light emission in the sub-pixels.

In some implementations, as shown in FIG. 19, the first sub-pixels sp1 are irregularly-shaped sub-pixels spz, the second virtual quadrilateral 20 formed by four third sub-pixels sp3 is a square, the fourth virtual quadrilateral 40 formed by four second sub-pixels sp2 is a square, and one second virtual quadrilateral 20 is provided inside the fourth virtual quadrilateral 40. In a solution where the third sub-pixel sp3 is a green sub-pixel, one of the first sub-pixel sp1 and the second sub-pixel sp2 is a red sub-pixel and the other is a blue sub-pixel, by configuring the second virtual quadrilateral 20 formed by the four third sub-pixels sp3 to be a square, green sub-pixels are substantially located on the same straight line in the row direction, and are also substantially located on the same straight line in the column direction, and the green sub-pixels are relatively uniformly distributed in both the row direction and the column direction. When a sub-pixel rendering method is used for display, the display effect of straight lines in the horizontal and vertical directions is better. Furthermore, since the fourth virtual quadrilateral 40 formed by the four second sub-pixels sp2 is a square, the second sub-pixels sp2 are substantially located on the same straight line in the row direction, and are also substantially located on the same straight line in the column direction, and the second sub-pixels sp2 are relatively uniformly distributed in both the row direction and the column direction. On this basis, by adjusting the elliptical-arc orientations of the irregularly-shaped sub-pixels spz, the first virtual quadrilateral 10 can have different shapes, and thus it is easier to achieve relatively uniform distances between the first sub-pixels sp1 and the adjacent second sub-pixels sp2 , thereby achieving the technical effect of mitigating the unintended light emission in the sub-pixels.

As shown in FIG. 19, at the position of the third virtual quadrilateral 30, two first virtual sub-quadrilaterals 11 are adjacent to each other in the first direction x and share a virtual edge, and two third virtual sub-quadrilaterals 13 are adjacent to each other in the first direction x and share a virtual edge. In the embodiment of the present disclosure, by configuring the elliptical-arc orientations of the first sub-pixels sp1, two first virtual sub-quadrilaterals 11 and two third virtual sub-quadrilaterals 13 are formed at the position of the third virtual quadrilateral 30. Through cooperation, the distances between the first sub-pixels sp1 and the adjacent second sub-pixels sp2 can be relatively uniform, which is conducive to mitigating the issue of unintended light emission in the sub-pixels.

As shown in FIG. 19, the first sub-pixels sp1 are irregularly-shaped sub-pixels spz, the fourth virtual quadrilateral 40 formed by four second sub-pixels sp2 is a square, and one second virtual quadrilateral 20 is provided inside the fourth virtual quadrilateral 40. Four first sub-pixels sp1 form a third virtual quadrilateral 30, the third virtual quadrilateral 30 is a parallelogram, and the second virtual quadrilateral 20 inside the third virtual quadrilateral 30 is a square; and the four first virtual quadrilaterals 10 at the position of the third virtual quadrilateral 30 are irregular quadrilaterals. In this embodiment, the first virtual quadrilaterals 10 are all irregular quadrilaterals, achieving relatively uniform distances between the first sub-pixels sp1 and the adjacent second sub-pixels sp2, which is conducive to mitigating the issue of unintended light emission in the sub-pixels.

In some implementations, as shown in FIG. 20, the elliptical-arc orientation of the first sub-pixel sp1 positioned on the third virtual quadrilateral 30 is parallel to or perpendicular to the first direction x; there are four first virtual quadrilaterals 10 at the position of the third virtual quadrilateral 30; and on the third virtual quadrilateral 30, the elliptical-arc orientations of two adjacent first sub-pixels sp1 in the second direction y are opposite to each other, and the first direction x intersects the second direction y. In the first virtual quadrilateral 10, the centers of the two first sub-pixels sp1 are equidistant from the center of the third sub-pixel sp3, the centers of the two second sub-pixels sp2 are equidistant from the center of the third sub-pixel sp3, and the centers of the first sub-pixel sp1 and the second sub-pixel sp2 are non-equidistant from the center of the third sub-pixel sp3. In this embodiment, the elliptical-arc orientation of the first sub-pixel sp1 positioned inside the third virtual quadrilateral 30 is perpendicular to the elliptical-arc orientations of the first sub-pixels sp1 positioned at the vertexes of the third virtual quadrilateral 30, so that the first virtual quadrilateral 10 is formed as an irregular quadrilateral, thus achieving relatively uniform distances between the first sub-pixels sp1 and the adjacent second sub-pixels sp2. In the first virtual quadrilateral 10, the centers of the two first sub-pixels sp1 are configured to be equidistant from the center of the third sub-pixel sp3, and the centers of the two second sub-pixels sp2 are configured to be equidistant from the center of the third sub-pixel sp3. When a sub-pixel rendering method is used for display, the difference in display effects of the pixels including the first sub-pixels sp1 is small, and the overall display effect is better.

As shown in FIG. 20, in the first virtual quadrilateral 10 at the position of the third virtual quadrilateral 30, the centers of the two first sub-pixels sp1 are equidistant from the center of the third sub-pixel sp3, and the centers of the two second sub-pixels sp2 are equidistant from the center of the third sub-pixel sp3. Moreover, the first virtual quadrilateral 10 includes a fourth virtual sub-quadrilateral 14 and a fifth virtual sub-quadrilateral 15; in the fourth virtual sub-quadrilateral 14, the distance between the center of the first sub-pixel sp1 and the center of the third sub-pixel sp3 is d₆; and in the fifth virtual sub-quadrilateral 15, the distance between the center of the first sub-pixel sp1 and the center of the third sub-pixel sp3 is d₇, where d₇>d₆. At the position of the third virtual quadrilateral 30, two fourth virtual sub-quadrilaterals are adjacent to each other in the second direction and share a virtual edge, and two fifth virtual sub-quadrilaterals are adjacent to each other in the second direction and share a virtual edge. In this embodiment, by configuring the elliptical-arc orientation of the first sub-pixel sp1 positioned inside the third virtual quadrilateral 30 and the elliptical-arc orientations of the first sub-pixels sp1 positioned at the vertexes of the third virtual quadrilateral 30 to be perpendicular to each other, two types of first virtual quadrilaterals 10 can be formed at the position of the third virtual quadrilateral 30. The two types of first virtual quadrilaterals 10 respectively have different distances between the centers of the first sub-pixel sp1 and the third sub-pixel sp3. Such a configuration can, in conjunction with the design of the elliptical-arc orientations of the first sub-pixels sp1, achieve more compact arrangement of the three types of sub-pixels, ensure space utilization, and achieve relatively uniform distances between the first sub-pixels sp1 and adjacent second sub-pixels sp2.

In some implementations, as shown in FIG. 20, the first sub-pixels sp1 are irregularly-shaped sub-pixels spz, four first sub-pixels sp1 form a third virtual quadrilateral 30, the third virtual quadrilateral 30 is a trapezoid, and the second virtual quadrilateral 20 inside the third virtual quadrilateral 30 is a square; and the four first virtual quadrilaterals 10 located at the position of the third virtual quadrilateral 30 are irregular quadrilaterals. In this embodiment, the first virtual quadrilaterals 10 are all irregular quadrilaterals, achieving relatively uniform distances between the first sub-pixels sp1 and the adjacent second sub-pixels sp2, which is conducive to mitigating the issue of unintended light emission in the sub-pixels. In a solution where the third sub-pixel sp3 is a green sub-pixel, one of the first sub-pixel sp1 and the second sub-pixel sp2 is a red sub-pixel and the other is a blue sub-pixel, by configuring the second virtual quadrilateral 20 formed by the four third sub-pixels sp3 to be a square, green sub-pixels are substantially located on the same straight line in the row direction, and are also substantially located on the same straight line in the column direction, and the green sub-pixels are relatively uniformly distributed in both the row direction and the column direction. When a sub-pixel rendering method is used for display, the display effect of straight lines in the horizontal and vertical directions is better. Furthermore, the fourth virtual quadrilateral 40 formed by the four second sub-pixels sp2 is a square, and one second virtual quadrilateral 20 is provided inside the fourth virtual quadrilateral 40, the second sub-pixels sp2 are substantially located on the same straight line in the row direction, and are also substantially located on the same straight line in the column direction, and the second sub-pixels sp2 are relatively uniformly distributed in both the row direction and the column direction. On this basis, by adjusting the elliptical-arc orientations of the irregularly-shaped sub-pixels spz, the first virtual quadrilateral 10 can have different shapes, and thus it is easier to achieve relatively uniform distances between the first sub-pixels sp1 and the adjacent second sub-pixels sp2 , thereby achieving the technical effect of mitigating the unintended light emission in the sub-pixels.

In the embodiment of FIG. 20, when the center of the second sub-pixel sp2 and the center of the first sub-pixel sp1 are located on the same straight line in the first direction x or on the same straight line in the second direction y, the four first virtual quadrilaterals 10 at the position of the third virtual quadrilateral 30 are each an irregular quadrilateral with one right interior angle.

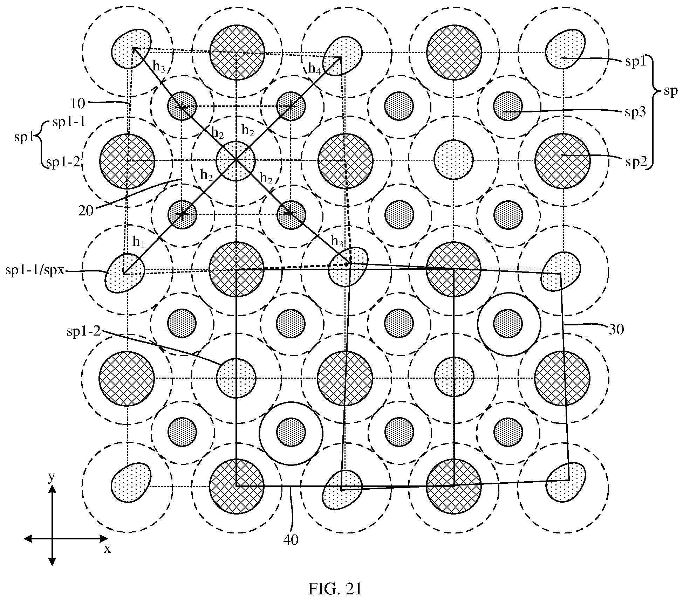

In some implementations, FIG. 21 is a schematic diagram of another display panel according to an embodiment of the present disclosure. As shown in FIG. 21, four first sub-pixels sp1 form a third virtual quadrilateral 30, the first sub-pixels sp1 include a first-type first sub-pixel sp1-1 and a second-type first sub-pixel sp-2. The first-type first sub-pixel sp1-1 is an irregularly-shaped sub-pixel spx, and a shape contour of the second-type first sub-pixel sp1-2 is circular. The first sub-pixels sp1 forming the third virtual quadrilateral 30 are the first-type first sub-pixels sp1-1, and the second-type first sub-pixel sp1-2 is positioned inside the third virtual quadrilateral. In this embodiment, it is configured that one of the two first sub-pixels sp1 positioned at opposite corners of the first virtual quadrilateral 10 is an irregularly-shaped sub-pixel spx, and the other is a regular sub-pixel. In conjunction with the elliptical-arc orientation designing of the irregularly-shaped sub-pixel spx, the shape of the first virtual quadrilateral 10 can be adjusted, achieving relatively uniform distances between the first sub-pixels sp1 and the second sub-pixels sp2 on the first virtual quadrilateral 10, which can mitigate the issue of unintended light emission in the sub-pixels.

In some implementations, the area of the first-type first sub-pixel sp1-1 is equal to the area of the second-type first sub-pixel sp1-2. By designing the shapes of the openings of the pixel definition layer corresponding to each of the two types of first sub-pixels sp1, the areas of the two types of first sub-pixels sp1 can be made equal. Such a configuration ensures that the two types of first sub-pixels sp1 make substantially equal contributions when cooperating with the sub-pixels of other colors for display, resulting in better overall display uniformity.

In some implementations, as shown in FIG. 21, there are four first virtual quadrilaterals 10 at the position of the third virtual quadrilateral 30; and in the first virtual quadrilaterals 10, the centers of the two first sub-pixels sp1 are non-equidistant from the center of the third sub-pixel sp3, and the centers of the two second sub-pixels sp2 are equidistant from the center of the third sub-pixel sp3. By configuring one of the two first sub-pixels sp1 positioned at opposite corners of the first virtual quadrilateral 10 to be an irregularly-shaped sub-pixel spx and the other to be a regular sub-pixel, the centers of the two first sub-pixels sp1 are non-equidistant from the center of the third sub-pixel sp3, so that the shape of the first virtual quadrilateral 10 can be adjusted, and on the first virtual quadrilateral 10, the distances between the first sub-pixels sp1 and the second sub-pixels sp2 are relatively uniform. For example, when the second virtual quadrilateral formed by the four third sub-pixels sp3 is a square, and the fourth virtual quadrilateral 40 formed by the four second sub-pixels sp2 is a square, the second-type first sub-pixel sp1-2 is equidistant from its four surrounding second sub-pixels sp2, the first virtual quadrilateral 10 is an irregular quadrilateral, and the differences in distances between adjacent first sub-pixels sp1 and second sub-pixels sp2 at different positions are relatively small.

As shown in FIG. 21, the elliptical-arc orientation of the first sub-pixel sp1 positioned on the third virtual quadrilateral 30 has an acute angle with the first direction x; and the first sub-pixel sp1 positioned inside the third virtual quadrilateral 30 is circular. In the four first virtual quadrilaterals 10 at the position of the third virtual quadrilateral 30: in one first virtual quadrilateral 10, the distance between the center of one first sub-pixel sp1 and the center of the third sub-pixel sp3 is h₁, and the distance between the center of the other first sub-pixel sp1 and the center of the third sub-pixel sp3 is h₂; in two first virtual quadrilaterals 10, the distance between the center of one first sub-pixel sp1 and the center of the third sub-pixel sp3 is h₃, and the distance between the center of the other first sub-pixel sp1 and the center of the third sub-pixel sp3 is h₂, where h₁>h₃; in one first virtual quadrilateral 10, the distance between the center of one first sub-pixel sp1 and the center of the third sub-pixel sp3 is h₄, and the distance between the center of the other first sub-pixel sp1 and the center of the third sub-pixel sp3 is h₂, where h₃>h₄. In this embodiment, the elliptical-arc orientations of the first sub-pixels sp1 positioned at opposite corners of the third virtual quadrilateral 30 are configured to be the same, the elliptical-arc orientation of each first sub-pixel sp1 has an acute angle with the first direction x, and first virtual quadrilaterals 10 of three sizes are formed at the position of the third virtual quadrilateral 30. In practice, the first virtual quadrilaterals 10 of three sizes are obtained by adjusting the elliptical-arc orientations of the first sub-pixels sp1 at the vertexes of the third virtual quadrilateral 30, achieving relatively uniform distances between the first sub-pixels sp1 and the second sub-pixels sp2 on the first virtual quadrilateral 10, which is conducive to mitigating the issue of unintended light emission in the sub-pixels.

As shown in FIG. 21, a subset of the plurality of first sub-pixels sp1 are irregularly-shaped sub-pixels spz, and a subset of the plurality of first sub-pixels sp1 are circular sub-pixels; the second virtual quadrilateral 20 formed by four third sub-pixels sp3 is a square, the fourth virtual quadrilateral 40 formed by four second sub-pixels sp2 is a square, and one second virtual quadrilateral 20 is provided inside the fourth virtual quadrilateral 40. The first sub-pixels sp1 forming the third virtual quadrilateral 30 are irregularly-shaped sub-pixels spz, and the first sub-pixel sp1 positioned inside the third virtual quadrilateral 30 is a circular sub-pixel. The third virtual quadrilateral 30 is an irregular quadrilateral, and the second virtual quadrilateral 20 inside the third virtual quadrilateral 30 is a square; and the four first virtual quadrilaterals 10 at the position of the third virtual quadrilateral 30 are irregular quadrilaterals. In this embodiment, the first virtual quadrilaterals 10 are all irregular quadrilaterals, achieving relatively uniform distances between the first sub-pixels sp1 and the adjacent second sub-pixels sp2, which is conducive to mitigating the issue of unintended light emission in the sub-pixels.

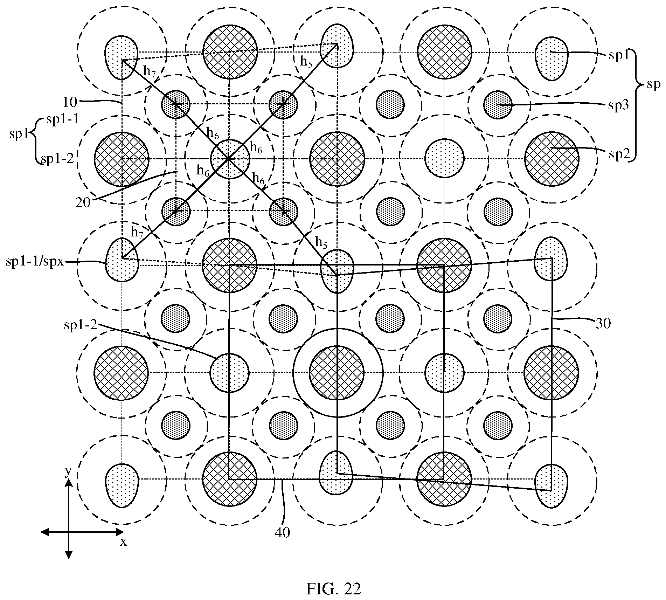

In some other implementations, FIG. 22 is a schematic diagram of another display panel according to an embodiment of the present disclosure. As shown in FIG. 22, four first sub-pixels sp1 form a third virtual quadrilateral 30; and the first sub-pixels sp1 include a first-type first sub-pixel sp1-1 and a second-type first sub-pixel sp1-2, the first-type first sub-pixel sp1-1 is an irregularly-shaped sub-pixel spx, and a shape contour of the second-type first sub-pixel sp1-2 is circular. The first sub-pixels sp1 forming the third virtual quadrilateral 30 are the first-type first sub-pixels sp1-1, and the second-type first sub-pixel sp1-2 is positioned inside the third virtual quadrilateral. The elliptical-arc orientation of the first sub-pixel sp1 positioned on the third virtual quadrilateral 30 is parallel to or perpendicular to the first direction x, where FIG. 22 illustrates the perpendicular case.

In the four first virtual quadrilaterals 10 at the position of the third virtual quadrilateral 30: in two first virtual quadrilaterals 10, the distance between the center of one first sub-pixel sp1 and the center of the third sub-pixel sp3 is h₅, and the distance between the center of the other first sub-pixel sp1 and the center of the third sub-pixel sp3 is h₆; in the other two first virtual quadrilaterals 10, the distance between the center of one first sub-pixel sp1 and the center of the third sub-pixel sp3 is h₇, and the distance between the center of the other first sub-pixel sp1 and the center of the third sub-pixel sp3 is h₆, where h₅>h₇. Optionally, h₆>h₇, or h₆=h₇. In this embodiment, the third virtual quadrilateral 30 is a trapezoid, and the four first virtual quadrilaterals 10 at a position of the third virtual quadrilateral 30 are irregular quadrilaterals. By adjusting the elliptical-arc orientations of the first sub-pixels sp1 at the vertexes of the third virtual quadrilateral 30, two types of irregular first virtual quadrilaterals 10 are formed, achieving relatively uniform distances between the first sub-pixels sp1 and the second sub-pixels sp2 on the first virtual quadrilateral 10, which is conducive to mitigating the issue of unintended light emission in the sub-pixels. Furthermore, configuring the plurality of first sub-pixels sp1 across the entire surface of the display panel to have different elliptical-arc orientations is conducive to mitigating the color shift at display viewing angles and enhancing the wide-angle display effect.

In addition, in the embodiment of FIG. 22, there are four first virtual quadrilaterals 10 at the position of the third virtual quadrilateral 30; and in the four first virtual quadrilaterals 10, the centers of the second sub-pixels sp2 are equidistant from the center of the third sub-pixel sp3. The fourth virtual quadrilateral 40 formed by four second sub-pixels sp2 is a square, and one second virtual quadrilateral 20 is provided inside the fourth virtual quadrilateral 40. The second virtual quadrilateral 20 formed by four third sub-pixels sp3 is a square. In a solution where the third sub-pixel sp3 is a green sub-pixel, one of the first sub-pixel sp1 and the second sub-pixel sp2 is a red sub-pixel and the other is a blue sub-pixel, by configuring the second virtual quadrilateral 20 formed by the four third sub-pixels sp3 to be a square, green sub-pixels are substantially located on the same straight line in the row direction, and are also substantially located on the same straight line in the column direction, and the green sub-pixels are relatively uniformly distributed in both the row direction and the column direction. When a sub-pixel rendering method is used for display, the display effect of straight lines in the horizontal and vertical directions is better.

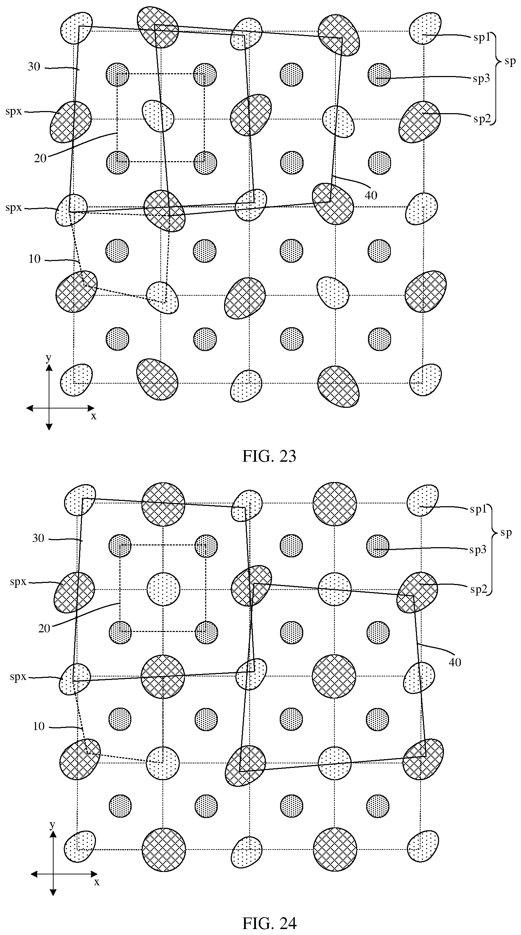

In the embodiment of FIG. 22, when the center of the second sub-pixel sp2 and the center of the first sub-pixel sp1 are located on the same straight line in the second direction y, the four first virtual quadrilaterals 10 at the position of the third virtual quadrilateral 30 are each an irregular quadrilateral with two right interior angles. In some implementations, FIG. 23 is a schematic diagram of another display panel according to an embodiment of the present disclosure. As shown in FIG. 23, four first sub-pixels sp1 form a third virtual quadrilateral 30; and one second virtual quadrilateral 20 is positioned inside the third virtual quadrilateral 30, and one first sub-pixel sp1 is provided inside the second virtual quadrilateral 20. The display panel includes a fourth virtual quadrilateral 40, and four second sub-pixels sp2 form the fourth virtual quadrilateral 40; and one second virtual quadrilateral 20 is positioned inside the fourth virtual quadrilateral 40, and one second sub-pixel sp2 is provided inside the second virtual quadrilateral 20. The four first sub-pixels sp1 forming the third virtual quadrilateral 30 are all irregularly-shaped sub-pixels spx, and the four second sub-pixels sp2 forming the fourth virtual quadrilateral 40 are all irregularly-shaped sub-pixels spx. In the third virtual quadrilateral 30, the elliptical-arc orientations of the two first sub-pixels sp1 positioned at opposite corners are perpendicular to each other. In the fourth virtual quadrilateral 40, the elliptical-arc orientations of the two second sub-pixels sp2 positioned at opposite corners are perpendicular to each other. In this embodiment, by configuring the first sub-pixels sp1 and the second sub-pixels sp2 to be irregularly-shaped sub-pixels spx, the shape of the first virtual quadrilateral 10 can be more varied; and by designing the elliptical-arc orientations of the irregularly-shaped sub-pixels spx, the distances between the first sub-pixels sp1 and the second sub-pixels sp2 can be finely adjusted, achieving relatively uniform distances between the first sub-pixels sp1 and the second sub-pixels sp2, which is conducive to mitigating the issue of unintended light emission in the sub-pixels.

In some implementations, in the embodiment of FIG. 23, the second virtual quadrilateral 20 formed by the four third sub-pixels sp3 is a square.

In another embodiment, in the third virtual quadrilateral 30, the elliptical-arc orientations of the two first sub-pixels sp1 positioned at the opposite corners are parallel to each other; and in the fourth virtual quadrilateral 40, the elliptical-arc orientations of the two second sub-pixels sp2 positioned at the opposite corners are parallel to each other, which are not illustrated in the drawings.

In some implementations, as shown in FIG. 23, on the third virtual quadrilateral 30, the elliptical-arc orientations of two adjacent first sub-pixels sp1 in the first direction x are different from each other, and the elliptical-arc orientations of two adjacent first sub-pixels sp1 in the second direction y are different from each other; and the first direction intersects the second direction; and/or, on the fourth virtual quadrilateral 40, the elliptical-arc orientations of two adjacent second sub-pixels sp2 in the first direction x are different from each other, and the elliptical-arc orientations of two adjacent second sub-pixels sp2 in the second direction y are different from each other. Such a configuration achieves relatively uniform distances between the first sub-pixels sp1 and second sub-pixels sp2 across the entire display region of the display panel, which can mitigate the issue of unintended light emission in the sub-pixels. In addition, configuring the plurality of first sub-pixels sp1 across the entire surface of the display panel to have different elliptical-arc orientations is conducive to mitigating the color shift at display viewing angles and enhancing the wide-angle display effect.

In some implementations, as shown in FIG. 23, the first sub-pixel sp1 inside the third virtual quadrilateral 30 is an irregularly-shaped sub-pixel spx, and the elliptical-arc orientation of the first sub-pixel sp1 is different from the elliptical-arc orientations of the first sub-pixels sp1 positioned on the third virtual quadrilateral 30; and the second sub-pixel sp2 positioned inside the fourth virtual quadrilateral 40 is an irregularly-shaped sub-pixel spx, and the elliptical-arc orientation of the second sub-pixel sp2 is different from the elliptical-arc orientations of the second sub-pixels sp2 positioned on the fourth virtual quadrilateral 40.

In some other implementations, FIG. 24 is a schematic diagram of another display panel according to an embodiment of the present disclosure. As shown in FIG. 24, four first sub-pixels sp1 form a third virtual quadrilateral 30; and one second virtual quadrilateral 20 is positioned inside the third virtual quadrilateral 30, and one first sub-pixel sp1 is provided inside the second virtual quadrilateral 20. The display panel includes a fourth virtual quadrilateral 40, four second sub-pixels sp2 form the fourth virtual quadrilateral 40; and one second virtual quadrilateral 20 is positioned inside the fourth virtual quadrilateral 40, and one second sub-pixel sp2 is provided inside the second virtual quadrilateral 20. The four first sub-pixels sp1 forming the third virtual quadrilateral 30 are all irregularly-shaped sub-pixels spx, and the four second sub-pixels sp2 forming the fourth virtual quadrilateral 40 are all irregularly-shaped sub-pixels spx. A shape contour of the first sub-pixel sp1 positioned inside the third virtual quadrilateral 30 is circular; and a shape contour of the second sub-pixel sp2 positioned within the fourth virtual quadrilateral 40 is circular. In this embodiment, a subset of the plurality of first sub-pixels sp1 are irregularly-shaped sub-pixels spx, and a subset of the plurality of first sub-pixels sp1 are circular sub-pixels; and a subset of the plurality of second sub-pixels sp2 are irregularly-shaped sub-pixels spx, and a subset of the plurality of second sub-pixels sp2 are circular sub-pixels. By designing the elliptical-arc orientations of the first sub-pixels sp1 and the elliptical-arc orientations of the second sub-pixels sp2, the distances between the first sub-pixels sp1 and the second sub-pixels sp2 can be finely adjusted, achieving relatively uniform distances between the first sub-pixels sp1 and the second sub-pixels sp2, which can mitigate the issue of unintended light emission in the sub-pixels.

In some other implementations, in the display panel, the plurality of first sub-pixels sp1 are all irregularly-shaped sub-pixels spx; and a subset of the plurality of second sub-pixels sp2 are irregularly-shaped sub-pixels spx, and a subset of the plurality of second sub-pixels sp2 are circular sub-pixels. In some other implementations, in the display panel, the plurality of second sub-pixels sp2 are all irregularly-shaped sub-pixels spx; and a subset of the plurality of first sub-pixels sp1 are irregularly-shaped sub-pixels spx, and a subset of the plurality of first sub-pixels sp1 are circular sub-pixels. The above two cases are not illustrated in the drawings.

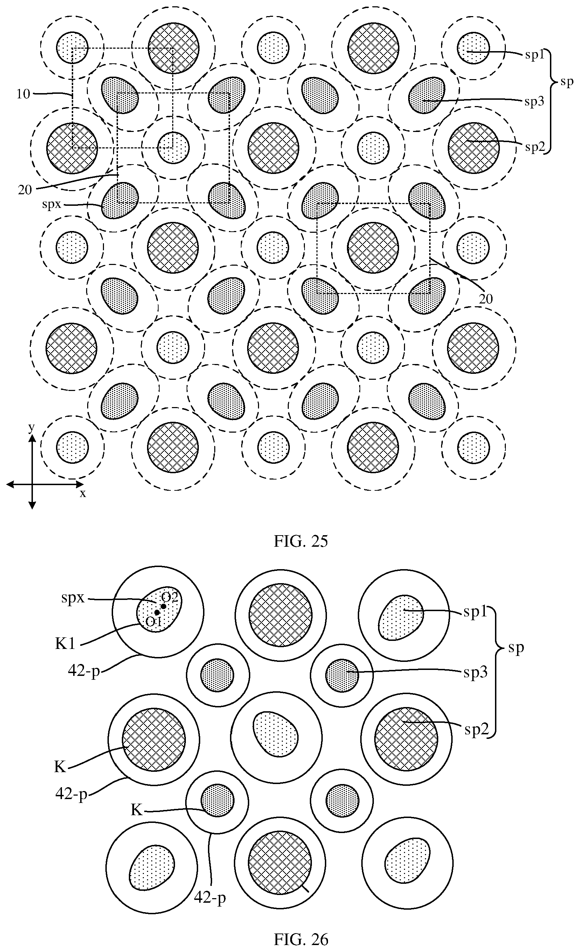

In some implementations, FIG. 25 is a schematic diagram of another display panel according to an embodiment of the present disclosure. As shown in FIG. 25, two first sub-pixels sp1 and two second sub-pixels sp2 form a first virtual quadrilateral 10; the two first sub-pixels sp1 are positioned at a pair of opposite corners of the first virtual quadrilateral 10, the two second sub-pixels sp2 are positioned at the other pair of opposite corners of the first virtual quadrilateral 10, and one third sub-pixel sp3 is positioned inside the first virtual quadrilateral 10; and four third sub-pixels sp3 form a second virtual quadrilateral 20, and one first sub-pixel sp1 or one second sub-pixel sp2 is positioned inside the second virtual quadrilateral 20. The third sub-pixels sp3 forming the second virtual quadrilateral 20 are all irregularly-shaped sub-pixels spx. In this embodiment, the third sub-pixels sp3 are configured to be irregularly-shaped sub-pixels spz; when the three types of sub-pixels are closely arranged, the distances between the third sub-pixels spz and the sub-pixels of other colors can be changed by adjusting the elliptical-arc orientations of the irregularly-shaped sub-pixels spz, achieving relatively uniform distances between adjacent sub-pixels of different colors, which can mitigate the issue of unintended light emission in the sub-pixels.

As shown in FIG. 25, on the second virtual quadrilateral 20, the elliptical-arc orientations of the four third sub-pixels sp3 are different from each other, and the elliptical-arc orientations of the two third sub-pixels sp3 positioned at opposite corners of the second virtual quadrilateral 20 are opposite to each other. Such a configuration enables the arrangement of three types of sub-pixels to be more compact, thereby improving the space utilization of the display panel. Moreover, configuring the plurality of third sub-pixels sp3 across the entire surface of the display panel to have different elliptical-arc orientations is conducive to mitigating the color shift at display viewing angles and enhancing the wide-angle display effect.

In some implementations, the first virtual quadrilateral 10 is a square, and the second virtual quadrilateral 20 is a parallelogram. Optionally, the second virtual quadrilateral 20 is a rectangle. Such a configuration enables the third sub-pixels sp3 to be uniformly distributed in the first direction x and the second direction y. Since the human eye is more sensitive to green light, when the third sub-pixels sp3 are green sub-pixels, the overall display effect is better.

As can be seen in conjunction with FIG. 13, the pixel definition layer 05 of the display panel includes a plurality of openings K, each sub-pixel sp includes one opening K; and the plurality of openings K include a first opening K1, and the irregularly-shaped sub-pixel spx includes the first opening K1. The sub-pixel sp includes a first electrode 41, a light-emitting layer 42, and a second electrode 43. In some implementations, the area of the light-emitting layer 42 of the irregularly-shaped sub-pixel spx is larger than the area of the first opening K1.

FIG. 26 is a simplified schematic diagram of another display panel according to an embodiment of the present disclosure. FIG. 26 illustrates the pattern 42-p of the light-emitting layer of each sub-pixel sp and the corresponding opening K. The first sub-pixel sp1 is illustrated as an irregularly-shaped sub-pixel spx. As shown in FIG. 26, in the irregularly-shaped sub-pixel spx, the pattern 42-p of the light-emitting layer is circular, and the center O1 of the pattern 42-p of the light-emitting layer is non-coincident with the center O2 of the first opening K1. The pattern shape of the first opening K1 is the same as the contour shape of the irregularly-shaped sub-pixel spx, and the center O2 of the first opening K1 is the center of gravity of its pattern shape. In some other implementations, the pattern 42-p of the light-emitting layer is rectangular, which is not illustrated herein. During the manufacture of the display panel, the light-emitting layer 42 is formed by an evaporative deposition process; the light-emitting layer 42 is deposited in the opening K and extends to the outside of the opening K; and the shape of the hollow of a mask in the evaporative deposition process is the same as the pattern shape of the light-emitting layer. In the embodiment of the present disclosure, the center O1 of the pattern 42-p of the light-emitting layer in the irregularly-shaped sub-pixel spz is non-coincident with the center O2 of the first opening K1, and thus it is not necessary to adapt the shape of the mask to that of the irregularly-shaped sub-pixel spz during evaporative deposition.

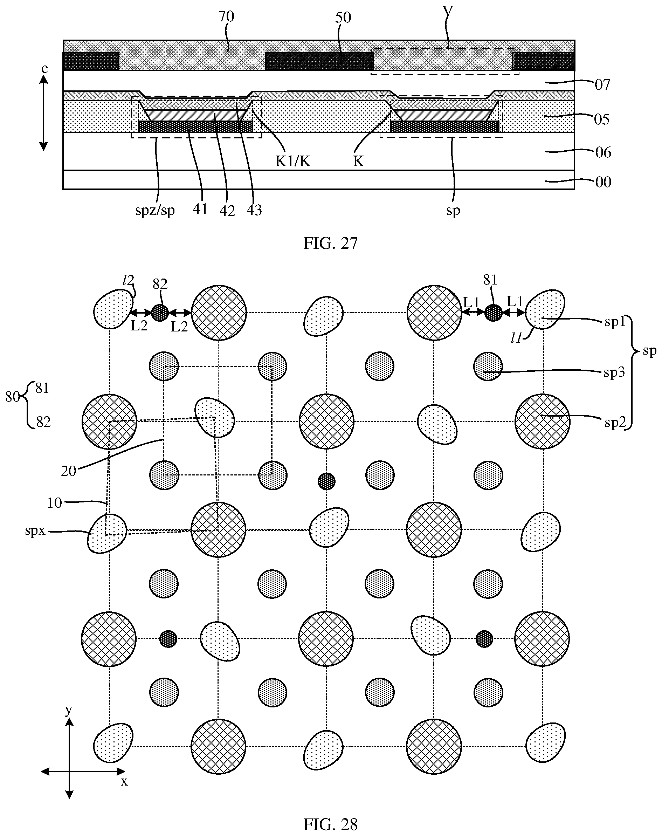

In some implementations, FIG. 27 is a schematic diagram of another display panel according to an embodiment of the present disclosure. As shown in FIG. 27, the display panel includes a substrate 00, a light-blocking structure 50, and a reflection control layer 70; the light-blocking structure 50 is positioned on one side of the sub-pixels sp away from the substrate 00; and the light-blocking structure 50 includes a plurality of hollows V. Along a direction e perpendicular to a plane of the substrate 00, the hollow V at least partially overlaps the sub-pixel sp. The reflection control layer 70 is positioned on one side of the light-blocking structure 50 away from the substrate 00 and at least partially within the hollows V. The reflection control layer 70 is a monolithic layer; or in other words reflection control layers 70 overlapping the sub-pixels sp of different colors are interlinked to form a monolithic structure. The reflection control layer 70 is an anti-reflection layer, which has the function of reducing the reflection of ambient light by the display panel. The reflection control layer 70 can selectively absorb some wavebands of ambient light incident on the display panel or absorb some wavebands of light reflected from the inside of the display panel. For example, the sub-pixels sp include red sub-pixels, green sub-pixels, and blue sub-pixels, the reflection control layer 70 can absorb light in wavebands that deviate from the emission wavelength ranges of the red sub-pixels, green sub-pixels, and blue sub-pixels, thereby avoiding the reduction of display brightness while reducing the reflection of ambient light by the display panel. The reflection control layer 70 is made of a dye and a pigment.

In some implementations, the display panel further includes a supporting post, an orthographic projection of the supporting post onto the substrate is located between an orthographic projection of the first sub-pixel sp1 onto the substrate and an orthographic projection of the second sub-pixel sp2 onto the substrate. The supporting post is configured to support the mask during the evaporative deposition process to ensure the uniformity of evaporative deposition and improve the yield of evaporative deposition.

FIG. 28 is a schematic diagram of another display panel according to an embodiment of the present disclosure. FIG. 28 is a top view. It can be understood that in the top view, the supporting post coincides with its orthographic projection onto the substrate, and in the top view, each sub-pixel coincides with its orthographic projection onto the substrate. As shown in FIG. 28, the case where the first sub-pixel sp1 is an irregularly-shaped sub-pixel spx is taken as an example. The supporting post 80 includes a first supporting post 81 and a second supporting post 82. An orthographic projection of the first supporting post 81 onto the substrate is adjacent to an orthographic projection of the circular arc *l1* of an irregularly-shaped sub-pixel spx onto the substrate, and an orthographic projection of the second supporting post 82 onto the substrate is adjacent to an orthographic projection of the elliptical arc *l2* of an irregularly-shaped sub-pixel spx onto the substrate. Along a direction parallel to a plane of the substrate, a distance between the first supporting post 81 and the irregularly-shaped sub-pixel spx is equal to a distance between the first supporting post 81 and a second sub-pixel sp2, and a distance between the second supporting post 82 and the irregularly-shaped sub-pixel spx is smaller than a distance between the first supporting post 81 and the irregularly-shaped sub-pixel spx. FIG. 28 illustrates that the distance between the first supporting post 81 and the irregularly-shaped sub-pixel spx is L1, and the distance between the second supporting post 82 and the irregularly-shaped sub-pixel spx is L2, where L2<L1. The distance between a supporting post and an irregularly-shaped sub-pixel spx is represented by a minimum distance between them two, such as a distance between the supporting post and an edge of the first opening of the irregularly-shaped sub-pixel spx. The shape of the supporting post 80 in the top view of FIG. 28 is merely for schematic representation and is not intended to limit the present disclosure.

The irregularly-shaped sub-pixel spx illustrated in FIG. 28 has the shape illustrated in FIG. 11. The area of the irregularly-shaped sub-pixel spx is larger than the area of the virtual circle to which the circular arc *l1* belongs. Therefore, the distance between the circular arc *l1* of the irregularly-shaped sub-pixel spx and the second sub-pixel sp2 is smaller than the distance between the elliptical arc *l2* of the irregularly-shaped sub-pixel spx and the second sub-pixel sp2. In the embodiment of the present disclosure, by configuring L2<L1, the distance between the first supporting post 81 and the irregularly-shaped sub-pixel spx can be equal to the distance between the first supporting post 81 and the second sub-pixel sp2, and the distance between the second supporting post 82 and the irregularly-shaped sub-pixel spx is equal to the distance between the second supporting post 82 and the second sub-pixel sp2, thereby ensuring that the supporting posts can provide uniform support all over the mask and guaranteeing the yield of evaporative deposition.

In some implementations, the first sub-pixel sp1 as well as one second sub-pixel sp2 and one third sub-pixel sp3 adjacent thereto form one pixel, the first sub-pixel sp1 is shared by two adjacent pixels, and the second sub-pixel sp2 is shared by two adjacent pixels; and the third sub-pixel sp3 is not shared by pixels. In the entire display region of the display panel, a ratio of a number of pixels to a number of supporting posts 80 is 2:9. Such a configuration can ensure that the supporting posts provide effective and uniform support for the mask during the evaporative deposition process.

In some implementations, the display panel further includes a light sensor positioned on one side of the substrate. The light sensor may be an ambient light sensor for sensing the brightness of ambient light. The light sensor may also be an anti-mistouch sensor. The light sensor may also be an optical fingerprint sensor. The light sensor is provided in at least one display region of the display panel; an orthographic projection of the light sensor onto the substrate is located between the orthographic projections of adjacent first sub-pixel sp1 and second sub-pixel sp2 onto the substrate.

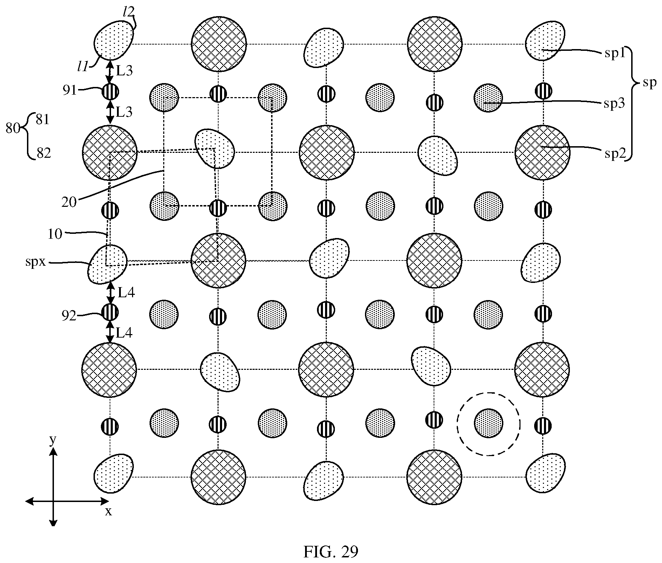

In an embodiment, FIG. 29 is a schematic diagram of another display panel according to an embodiment of the present disclosure. As shown in FIG. 29, the first sub-pixels sp1 are irregularly-shaped sub-pixels spx. The light sensor 90 includes a first light sensor 91 and a second light sensor 92; and an orthographic projection of the first light sensor 91 onto the substrate is adjacent to an orthographic projection of the circular arc *l1* of an irregularly-shaped sub-pixel spx onto the substrate, and an orthographic projection of the second light sensor 92 onto the substrate is adjacent to an orthographic projection of the elliptical arc *l2* of an irregularly-shaped sub-pixel spx onto the substrate. Along a direction parallel to a plane of the substrate, a distance between the first light sensor 91 and the irregularly-shaped sub-pixel spx is equal to a distance between the first light sensor 91 and the second sub-pixel sp2, and a distance between the second light sensor 92 and the irregularly-shaped sub-pixel spx is less than a distance between the first light sensor 91 and the irregularly-shaped sub-pixel spx. FIG. 29 illustrates that the distance between the first light sensor 91 and the irregularly-shaped sub-pixel spx is L3, and the distance between the second light sensor 92 and the irregularly-shaped sub-pixel spx is L4, where L4<L3. The distance between light sensor 90 and the irregularly-shaped sub-pixel spx is represented by a minimum distance between them two, such as a distance between the light sensor 90 and an edge of the first opening of the irregularly-shaped sub-pixel spx. The shape of the light sensor 90 in the top view of FIG. 29 is merely for schematic representation and is not intended to limit the present disclosure.

The irregularly-shaped sub-pixel spx shown in FIG. 29 has the shape shown in FIG. 11. The area of the irregularly-shaped sub-pixel spx is larger than the area of the virtual circle to which the circular arc *l1* belongs. Therefore, the distance between the circular arc *l1* of the irregularly-shaped sub-pixel spx and the second sub-pixel sp2 is smaller than the distance between the elliptical arc *l2* of the irregularly-shaped sub-pixel spx and the second sub-pixel sp2. In the embodiment of the present disclosure, by configuring L4<L3, the distance between the first light sensor 91 and the irregularly-shaped sub-pixel spx can be equal to the distance between the first light sensor 91 and a second sub-pixel sp2, and the distance between the second light sensor 92 and the irregularly-shaped sub-pixel spx is equal to the distance between the second light sensor 92 and the second sub-pixel sp2. In a display panel provided with a light-blocking structure (as illustrated in FIG. 13 or FIG. 27), a corresponding hollow for the light sensor 90 is provided on the light-blocking structure. In the embodiment of the present disclosure, the light sensor 90 is substantially disposed at a midpoint position between the two sub-pixels, so as to prevent the light sensor 90 from affecting the aperture ratio of the sub-pixel, and enable the size of the hollow of the light-blocking structure corresponding to the light sensor 90 to be large enough to guarantee the optical performance of the light sensor 90.

In some implementations, as shown in FIG. 29, the orthographic projection of the light sensor LS onto the substrate is located between the orthographic projections of adjacent first sub-pixel sp1 and second sub-pixel sp2 in the second direction y, and the second direction y is parallel to a plane of the substrate. The second direction y may be the direction in which the data line extend or the direction in which the scan line extend. The first sub-pixel sp1 as well as one second sub-pixel sp2 and one third sub-pixel sp3 adjacent thereto form one pixel. The first sub-pixel sp1 is shared by two adjacent pixels, the second sub-pixel sp2 is shared by two adjacent pixels, and the third sub-pixel sp3 is not shared by pixels. In the display region where the light sensor LS is disposed, a ratio of a number of pixels to a number of light sensors LS is 1:1. In the embodiment of the present disclosure, in the region where the light sensor LS is positioned, the density of light sensors LS is configured to be sufficiently high, and the light sensors LS are relatively uniformly distributed, which can ensure that the optical performance of the light sensors is reliable.

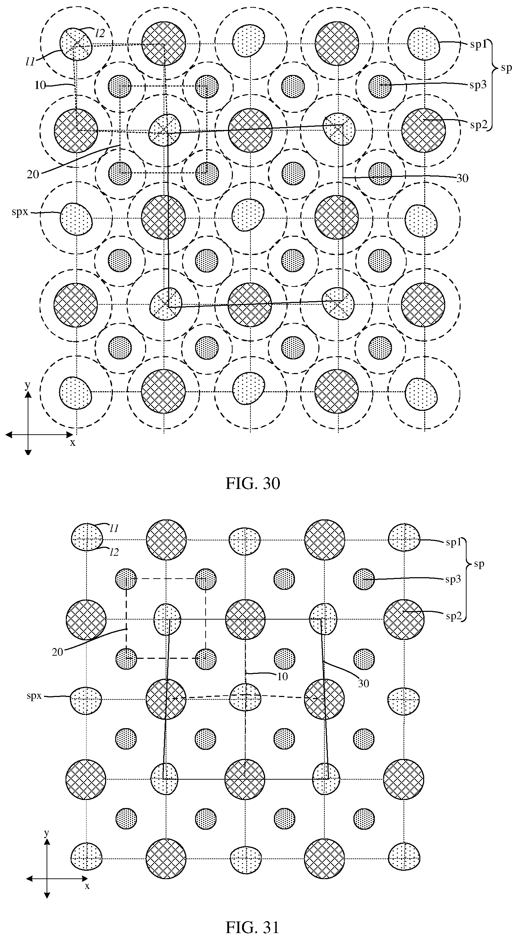

In the embodiments of FIG. 18 to FIG. 29, the irregularly-shaped sub-pixel spz is illustrated to have the shape illustrated in the embodiment of FIG. 11. Unless there is a conflict, the shape of the irregularly-shaped sub-pixel spz in the above embodiments may also be the shape illustrated in the embodiment of FIG. 12. The shape of the irregularly-shaped sub-pixel spz in FIG. 18 is replaced with the shape illustrated in the embodiment of FIG. 12 for illustration. FIG. 30 is a partial schematic diagram of another display panel according to an embodiment of the present disclosure. As shown in FIG. 30, the first sub-pixels sp1 are irregularly-shaped sub-pixels spz. Two first sub-pixels sp1 and two second sub-pixels sp2 form a first virtual quadrilateral 10. The two first sub-pixels sp1 are positioned at a pair of opposite corners of the first virtual quadrilateral 10, the two second sub-pixels sp2 are positioned at the other pair of opposite corners of the first virtual quadrilateral 10, and one third sub-pixel sp3 is positioned inside the first virtual quadrilateral 10. Four third sub-pixels sp3 form a second virtual quadrilateral 20, and a first sub-pixel sp1 or a second sub-pixel sp2 is positioned inside the second virtual quadrilateral 20. Four first sub-pixels sp1 form a third virtual quadrilateral 30, and the second virtual quadrilateral 20 is positioned inside the third virtual quadrilateral 30. In this embodiment, the elliptical-arc orientation of the irregularly-shaped sub-pixel spz form an acute angle with the first direction x. The elliptical-arc orientations of the first sub-pixels sp1 positioned at opposite corners of the third virtual quadrilateral 30 are perpendicular to each other. On the third virtual quadrilateral 30, the elliptical-arc orientations of two adjacent first sub-pixels sp1 in the first direction x are the same, or the elliptical-arc orientations of two adjacent first sub-pixels sp1 in the second direction y are the same. In this embodiment, the third virtual quadrilateral 30 is a parallelogram. The elliptical-arc orientation of the first sub-pixel sp1 inside the third virtual quadrilateral 30 is different from the elliptical-arc orientations of the first sub-pixels sp1 positioned on the third virtual quadrilateral 30. The four first virtual quadrilaterals 10 located at the position of the third virtual quadrilateral 30 may be irregular quadrilaterals.

In another embodiment, FIG. 31 is a schematic diagram of another display panel according to an embodiment of the present disclosure. As shown in FIG. 31, the first sub-pixels sp1 are irregularly-shaped sub-pixels spz, and the shape of the irregularly-shaped sub-pixel spz is the shape shown in the embodiment of FIG. 12. The elliptical-arc orientations of a subset of the irregularly-shaped sub-pixels spz are parallel to the first direction x, and the elliptical-arc orientations of a subset of the irregularly-shaped sub-pixels spz are parallel to the second direction y. Two first sub-pixels sp1 and two second sub-pixels sp2 form a first virtual quadrilateral 10, four third sub-pixels sp3 form a second virtual quadrilateral 20, and four first sub-pixels sp1 form a third virtual quadrilateral 30. The elliptical-arc orientation of the first sub-pixel sp1 positioned on the third virtual quadrilateral 30 is parallel to or perpendicular to the first direction x, and the elliptical-arc orientations of two adjacent first sub-pixels sp1 in the first direction x are different from each other, which enables the third virtual quadrilateral 30 to be a trapezoid. There are four first virtual quadrilaterals 10 at the position of the third virtual quadrilateral 30. The elliptical-arc orientation of the first sub-pixel sp1 positioned inside the third virtual quadrilateral 30 is different from the elliptical-arc orientations of the first sub-pixels sp1 positioned on the third virtual quadrilateral 30. The four first virtual quadrilaterals 10 are irregular quadrilaterals. When the center of the second sub-pixel sp2 and the center of the first sub-pixel sp1 are located on the same straight line in the first direction x or on the same straight line in the second direction y, the first virtual quadrilaterals 10 each are an irregular quadrilateral with one right interior angle. Furthermore, in this embodiment, the second virtual quadrilateral 20 may be a square.

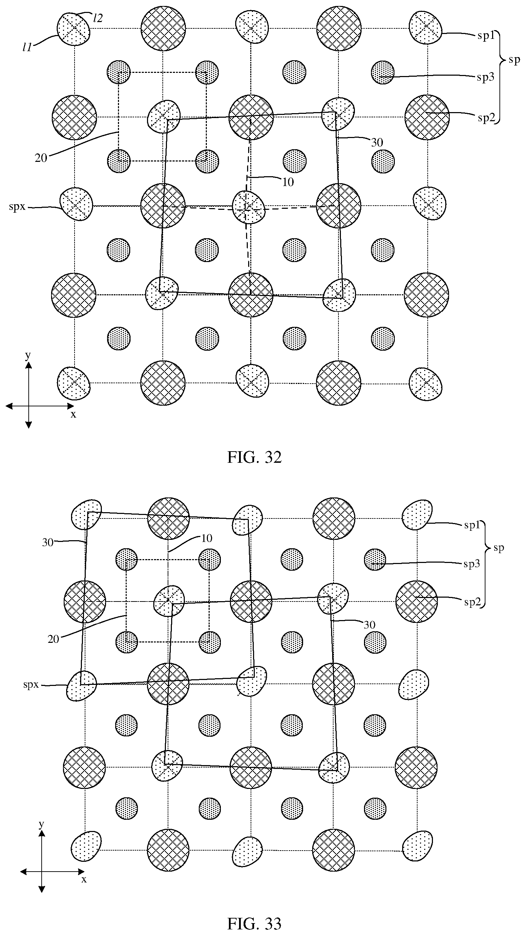

In another embodiment, FIG. 32 is a schematic diagram of another display panel according to an embodiment of the present disclosure. As shown in FIG. 32, the first sub-pixels sp1 are irregularly-shaped sub-pixels spz, and the shape of the irregularly-shaped sub-pixel spz is the shape shown in the embodiment of FIG. 12. Two first sub-pixels sp1 and two second sub-pixels sp2 form a first virtual quadrilateral 10, four third sub-pixels sp3 form a second virtual quadrilateral 20, and four first sub-pixels sp1 form a third virtual quadrilateral 30. The elliptical-arc orientation of the first sub-pixel sp1 positioned on the third virtual quadrilateral 30 form an acute angle with the first direction x. The elliptical-arc orientations of two adjacent first sub-pixels sp1 in the first direction x are different from each other, and the elliptical-arc orientations of two adjacent first sub-pixels sp1 in the second direction y are different from each other. The elliptical-arc orientations of the first sub-pixels sp1 positioned at opposite corners of the third virtual quadrilateral 30 are the same, which enables the third virtual quadrilateral 30 to be an irregular quadrilateral. There are four first virtual quadrilaterals 10 at the position of the third virtual quadrilateral 30. The elliptical-arc orientation of the first sub-pixel sp1 positioned inside the third virtual quadrilateral 30 is different from the elliptical-arc orientations of the first sub-pixels sp1 positioned on the third virtual quadrilateral 30. The four first virtual quadrilaterals 10 are irregular quadrilaterals. In addition, in this embodiment, the second virtual quadrilateral 20 may be a square.

In some other implementations, FIG. 33 is a schematic diagram of another display panel according to an embodiment of the present disclosure. As shown in FIG. 33, the first sub-pixels sp1 are irregularly-shaped sub-pixels spz, the shape of a subset of the irregularly-shaped sub-pixels spz is the shape shown in the embodiment of FIG. 12, and the shape of a subset of irregularly-shaped sub-pixels spz is the shape shown in the embodiment of FIG. 11. Two first sub-pixels sp1 and two second sub-pixels sp2 form a first virtual quadrilateral 10, four third sub-pixels sp3 form a second virtual quadrilateral 20, and four first sub-pixels sp1 form a third virtual quadrilateral 30. The third virtual quadrilateral 30 is an irregular quadrilateral. One of the first sub-pixels sp1 positioned at opposite corners of the first virtual quadrilateral 10 has the shape shown in FIG. 11, and the other has the shape shown in FIG. 12. In this embodiment, the four first virtual quadrilaterals 10 at the position of the third virtual quadrilateral 30 are irregular quadrilaterals.

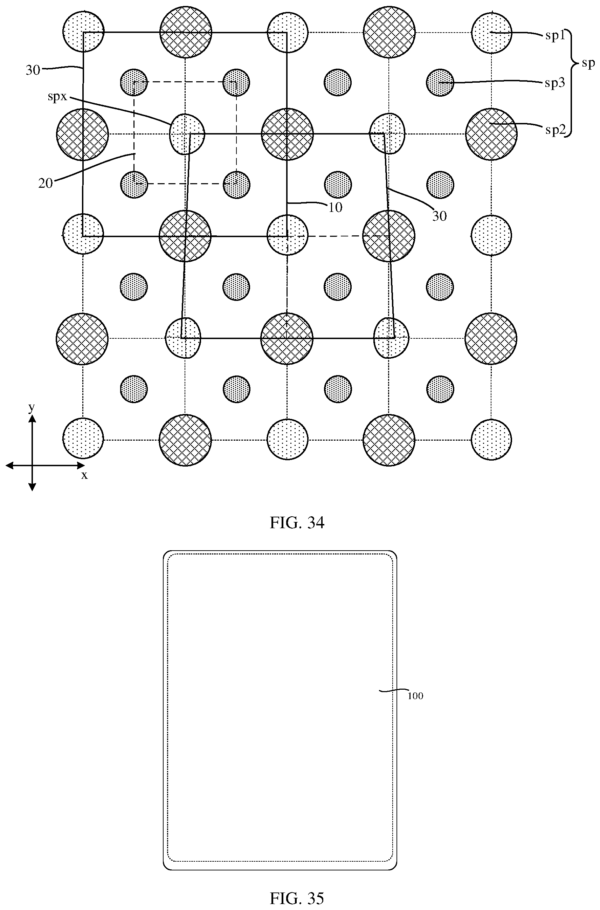

In some implementations, FIG. 34 is a schematic diagram of another display panel according to an embodiment of the present disclosure. As shown in FIG. 34, a subset of the plurality of first sub-pixels sp1 are irregularly-shaped sub-pixels spx and a subset of the plurality of first sub-pixels sp1 are circular. One circular first sub-pixel sp1 is provided in the third virtual quadrilateral 30 formed by four irregularly-shaped first sub-pixels sp1, and one irregularly-shaped first sub-pixel sp1 is provided inside the third virtual quadrilateral 30 formed by four circular first sub-pixels sp1. When the center of the circular first sub-pixel sp1 and the center of the second sub-pixel sp2 are located on the same straight line in the second direction y, the third virtual quadrilateral 30 formed by the four circular first sub-pixels sp1 is a square. The elliptical-arc orientations of the four irregularly-shaped first sub-pixels sp1 are parallel to the first direction x, and the elliptical-arc orientations of two first sub-pixels sp1 positioned on one edge of the third virtual quadrilateral 30 are opposite to each other, so that the third virtual quadrilateral 30 formed by the four irregularly-shaped first sub-pixels sp1 is a trapezoid. In this embodiment, one of the two first sub-pixels sp1 positioned at opposite corners of the first virtual quadrilateral 10 is circular and the other is irregularly-shaped, and the first virtual quadrilateral 10 may be an irregular quadrilateral.

Based on the same inventive concept, an embodiment of the present disclosure further provides a display apparatus. FIG. 35 is a schematic diagram of a display apparatus according to an embodiment of the present disclosure. As shown in FIG. 35, the display apparatus includes a display panel 100 according to any one of the embodiments of the present disclosure. The structure of the display panel 100 has been described in the above embodiments and is not repeated here. The display apparatus according to the embodiment of the present disclosure may be, for example, an electronic device with a display function, such as a mobile phone, tablet, computer, television, smart wearable product.

The above are merely preferred embodiments of the present disclosure, and are not intended to limit the present disclosure. Any modifications, equivalent substitutions, improvements, etc. made within the spirit and principle of the present disclosure shall all be included within the protection scope of the present disclosure.

Finally, it should be noted that the above embodiments are only used to illustrate the technical solutions of the present disclosure, rather than limiting them. Although the present disclosure has been described in detail with reference to the above embodiments, those of skill in the art should understand that they can still modify the technical solutions recited in the above embodiments, or make equivalent substitutions for some or all of the technical features therein; and these modifications or substitutions do not make the essence of the corresponding technical solutions deviate from the scope of the technical solutions of the respective embodiments of the present disclosure.

## Claims

1. A display panel, comprising a plurality of sub-pixels, wherein the plurality of sub-pixels comprise a first sub-pixel, a second sub-pixel, and a third sub-pixel having colors different from one another;
two first sub-pixels and two second sub-pixels form a first virtual quadrilateral, the two first sub-pixels are positioned at a pair of opposite corners of the first virtual quadrilateral, the two second sub-pixels are positioned at the other pair of opposite corners of the first virtual quadrilateral, and one third sub-pixel is positioned inside the first virtual quadrilateral;
four third sub-pixels form a second virtual quadrilateral, and one first sub-pixel or one second sub-pixel is positioned inside the second virtual quadrilateral; and
wherein at least one of the first sub-pixel, the second sub-pixel, and the third sub-pixel comprises an irregularly-shaped sub-pixel, a shape contour of the irregularly-shaped sub-pixel comprises a circular arc and an elliptical arc, and the circular arc and the elliptical arc are connected end to end.

2. The display panel according to claim 1, wherein
an ellipse to which the elliptical arc belongs is a virtual ellipse; and
the circular arc intersects a major axis of the virtual ellipse, or the circular arc intersects an extension line of a minor axis of the virtual ellipse.

3. The display panel according to claim 1, wherein
a circle to which the circular arc belongs is a virtual circle, and an ellipse to which the elliptical arc belongs is a virtual ellipse; and
a diameter of the virtual circle is a minor axis or a major axis of the virtual ellipse.

4. The display panel according to claim 1, wherein
a circle to which the circular arc belongs is a virtual circle; and
a connecting line between two intersection points of the circular arc and the elliptical arc passes through a circular center of the virtual circle.

5. The display panel according to claim 1, wherein
a circle to which the circular arc belongs is a virtual circle; and
two intersection points of the circular arc and the elliptical arc are a first intersection point and a second intersection point, a connecting line between the first intersection point and a circular center of the virtual circle is a first connecting line, a connecting line between the second intersection point and the circular center of the virtual circle is a second connecting line, and an angle between the first connecting line and the second connecting line is 180°.

6. The display panel according to claim 1, wherein
a circle to which the circular arc belongs is a virtual circle, and an ellipse to which the elliptical arc belongs is a virtual ellipse;
a connecting line between two intersection points of the circular arc and the elliptical arc is a first virtual line segment; and
a length of the first virtual line segment is smaller than a diameter of the virtual circle, and/or the length of the first virtual line segment is smaller than a length of a major axis or a minor axis of the virtual ellipse.

7. The display panel according to claim 1, comprising a substrate and a pixel definition layer positioned on one side of the substrate, wherein the pixel definition layer comprises a plurality of openings, and the sub-pixel comprises one opening; the plurality of openings comprise a first opening, and the irregularly-shaped sub-pixel comprises the first opening; a shape of an orthographic projection of the first opening onto the substrate is the same as the shape contour of the irregularly-shaped sub-pixel; and
wherein the display panel further comprises a light-blocking structure positioned on one side of the sub-pixels away from the substrate, wherein the light-blocking structure comprises a plurality of hollows, and the plurality of hollows comprise a first hollow; and along a direction perpendicular to a plane of the substrate, the first hollow at least partially overlaps the irregularly-shaped sub-pixel;
wherein a shape of an orthographic projection of the first hollow onto the substrate is the same as the shape of the orthographic projection of the first opening onto the substrate.

8. The display panel according to claim 7, further comprising a plurality of color light-filtering units, wherein the plurality of color light-filtering units comprise a first light-filtering unit; and the first light-filtering unit is partially positioned within the first hollow and extends to one side of the light-blocking structure away from the substrate; and
wherein a shape of an orthographic projection of the first light-filtering unit onto the substrate is the same as the shape of the orthographic projection of the first opening onto the substrate.

9. The display panel according to claim 1, comprising a substrate and a pixel definition layer positioned on one side of the substrate, wherein the pixel definition layer comprises a plurality of openings, and the sub-pixel comprises one opening; the plurality of openings comprise a first opening, and a shape of an orthographic projection of the first opening onto the substrate is the same as the shape contour of the irregularly-shaped sub-pixel;
the sub-pixel comprises a first electrode, a light-emitting layer, and a second electrode that are stacked, and the first electrode is positioned on one side of the second electrode close to the substrate; and
wherein a shape of an orthographic projection of the first electrode in the irregularly-shaped sub-pixel onto the substrate is the same as the shape of the orthographic projection of the first opening onto the substrate.

10. The display panel according to claim 1, wherein
an ellipse to which the elliptical arc belongs is a virtual ellipse; and
a connecting line between two intersection points of the circular arc and the elliptical arc is a first virtual line segment, and a major axis of the virtual ellipse is perpendicular to the first virtual line segment.

11. The display panel according to claim 10, wherein
a maximum distance between the circular arc and the first virtual line segment is a₁, and a maximum distance between the elliptical arc and the first virtual line segment is a₂, where a₁<a₂≤3*a₁.

12. The display panel according to claim 1, wherein
an ellipse to which the elliptical arc belongs is a virtual ellipse; and
a connecting line between two intersection points of the circular arc and the elliptical arc is a first virtual line segment, and a minor axis of the virtual ellipse is perpendicular to the first virtual line segment.

13. The display panel according to claim 12, wherein
a maximum distance between the elliptical arc and the first virtual line segment is c₁, and a maximum distance between the circular arc and the first virtual line segment is c₂, where 0.5≤c₁/c₂≤0.9.

14. The display panel according to claim 1, further comprising a third virtual quadrilateral, wherein four first sub-pixels form the third virtual quadrilateral; one second virtual quadrilateral is positioned inside the third virtual quadrilateral, and one first sub-pixel is positioned inside the second virtual quadrilateral; and wherein the four first sub-pixels forming the third virtual quadrilateral are irregularly-shaped sub-pixels;
in the irregularly-shaped sub-pixel, a direction from the circular arc to the elliptical arc is an elliptical-arc orientation; and
the elliptical-arc orientations of two first sub-pixels positioned at opposite corners of the third virtual quadrilateral are perpendicular to or parallel to each other.

15. The display panel according to claim 14, wherein
on the third virtual quadrilateral, the elliptical-arc orientations of two adjacent first sub-pixels along a first direction are different from each other, and the elliptical-arc orientations of two adjacent first sub-pixels along a second direction are the same or different from each other; and the first direction intersects the second direction.

16. The display panel according to claim 14, wherein
the elliptical-arc orientation of the first sub-pixel positioned on the third virtual quadrilateral forms an acute angle with a first direction, or the elliptical-arc orientation of the first sub-pixel positioned on the third virtual quadrilateral is parallel to or perpendicular to a first direction.

17. The display panel according to claim 14, wherein
the first sub-pixel positioned inside the third virtual quadrilateral is the irregularly-shaped sub-pixel, and the elliptical-arc orientation of the first sub-pixel is different from the elliptical-arc orientations of the first sub-pixels positioned on the third virtual quadrilateral.

18. The display panel according to claim 17, wherein
the elliptical-arc orientation of the first sub-pixel positioned inside the third virtual quadrilateral is perpendicular to the elliptical-arc orientation of at least one of the four first sub-pixels forming the third virtual quadrilateral.

19. The display panel according to claim 17, wherein
the elliptical-arc orientation of the first sub-pixel positioned on the third virtual quadrilateral forms an acute angle with a first direction;
there are four first virtual quadrilaterals at a position of the third virtual quadrilateral; and the four first virtual quadrilaterals comprise at least one first virtual sub-quadrilateral; and
in the first virtual sub-quadrilateral, centers of two first sub-pixels are non-equidistant from a center of the third sub-pixel, and centers of two second sub-pixels are equidistant from the center of the third sub-pixel.

20. The display panel according to claim 19, wherein
in the first virtual sub-quadrilateral, a distance between the center of one first sub-pixel and the center of the third sub-pixel is d₁, a distance between the center of the other first sub-pixel and the center of the third sub-pixel is d₂, and the distance between the centers of each of the two second sub-pixels and the center of the third sub-pixel is d₃; wherein d₁>d₃>d₂.

21. The display panel according to claim 20, wherein
on the third virtual quadrilateral, the elliptical-arc orientations of two adjacent first sub-pixels along a second direction are the same; and
the first virtual quadrilaterals further comprise a second virtual sub-quadrilateral, and
in the second virtual sub-quadrilateral, centers of two first sub-pixels are equidistant from the center of the third sub-pixel, and centers of two second sub-pixels are equidistant from the center of the third sub-pixel.

22. The display panel according to claim 21, wherein
there are two first virtual sub-quadrilaterals and two second virtual sub-quadrilaterals at the position of the third virtual quadrilateral, the two first virtual sub-quadrilaterals are adjacent to each other in the second direction and share a virtual edge, and the two second virtual sub-quadrilaterals are adjacent to each other in the second direction and share a virtual edge; and
in one second virtual sub-quadrilateral, the distance between the center of the first sub-pixel and the center of the third sub-pixel is d₁; and in the other second virtual sub-quadrilateral, the distance between the center of the first sub-pixel and the center of the third sub-pixel is d₄, where d₄>d₁.

23. The display panel according to claim 20, wherein
the third virtual quadrilateral is a parallelogram, and the second virtual quadrilateral inside the third virtual quadrilateral is a square; and
among the four first virtual quadrilaterals at the position of the third virtual quadrilateral: two first virtual quadrilaterals are irregular quadrilaterals, and the other two first virtual quadrilaterals are parallelograms.

24. The display panel according to claim 20, wherein
on the third virtual quadrilateral, the elliptical-arc orientations of two adjacent first sub-pixels in a second direction are different from each other, and the second direction intersects the first direction;
the first virtual quadrilaterals further comprise a third virtual sub-quadrilateral; and
in the third virtual sub-quadrilateral, a distance between a center of one first sub-pixel and the center of the third sub-pixel is d₁; and a distance between a center of the other first sub-pixel and the center of the third sub-pixel is d₅, where d₅>d₁; and centers of two second sub-pixels are equidistant from the center of the third sub-pixel.

25. The display panel according to claim 24, wherein
at the position of the third virtual quadrilateral, two first virtual sub-quadrilaterals are adjacent to each other in the first direction and share a virtual edge, and two third virtual sub-quadrilaterals are adjacent to each other in the first direction and share a virtual edge.

26. The display panel according to claim 20, wherein
the third virtual quadrilateral is a parallelogram, and the second virtual quadrilateral inside the third virtual quadrilateral is a square; and
the four first virtual quadrilaterals at the position of the third virtual quadrilateral are irregular quadrilaterals.

27. The display panel according to claim 17, wherein
the elliptical-arc orientation of the first sub-pixel positioned on the third virtual quadrilateral is parallel to or perpendicular to a first direction;
there are four first virtual quadrilaterals at a position of the third virtual quadrilateral; and on the third virtual quadrilateral, the elliptical-arc orientations of two adjacent first sub-pixels in a second direction are opposite to each other, and the first direction intersects the second direction; and
in the first virtual quadrilateral, centers of two first sub-pixels are equidistant from a center of the third sub-pixel, centers of two second sub-pixels are equidistant from the center of the third sub-pixel, and the centers of the first sub-pixel and the second sub-pixel are non-equidistant from the center of the third sub-pixel.

28. The display panel according to claim 27, wherein
the first virtual quadrilaterals comprise a fourth virtual sub-quadrilateral and a fifth virtual sub-quadrilateral;
in the fourth virtual sub-quadrilateral, a distance between the center of the first sub-pixel and the center of the third sub-pixel is d₆; and in the fifth virtual sub-quadrilateral, a distance between the center of the first sub-pixel and the center of the third sub-pixel is d₇, wherein d₇>d₆; and
at the position of the third virtual quadrilateral, two fourth virtual sub-quadrilaterals are adjacent to each other in the second direction and share a virtual edge, and two fifth virtual sub-quadrilaterals are adjacent to each other in the second direction and share a virtual edge.

29. The display panel according to claim 27, wherein
the third virtual quadrilateral is a trapezoid, and the second virtual quadrilateral inside the third virtual quadrilateral is a square; and
the four first virtual quadrilaterals at the position of the third virtual quadrilateral are irregular quadrilaterals.

30. The display panel according to claim 14, wherein
the first sub-pixel comprises a first-type first sub-pixel and a second-type first sub-pixel, the first-type first sub-pixel is the irregularly-shaped sub-pixel, and a shape contour of the second-type first sub-pixel is circular; and
the second-type first sub-pixel is positioned inside the third virtual quadrilateral.

31. The display panel according to claim 30, wherein
an area of the first-type first sub-pixel is equal to an area of the second-type first sub-pixel.

32. The display panel according to claim 30, wherein
there are four first virtual quadrilaterals at a position of the third virtual quadrilateral; and
in the first virtual quadrilateral, centers of two first sub-pixels are non-equidistant from a center of the third sub-pixel, and centers of two second sub-pixels are equidistant from the center of the third sub-pixel.

33. The display panel according to claim 32, wherein
the elliptical-arc orientation of the first sub-pixel positioned on the third virtual quadrilateral forms an acute angle with a first direction;
among the four first virtual quadrilaterals:
in one first virtual quadrilateral, a distance between the center of one first sub-pixel and the center of the third sub-pixel is h₁, and a distance between the center of the other first sub-pixel and the center of the third sub-pixel is h₂;
in two first virtual quadrilaterals, a distance between the center of one first sub-pixel and the center of the third sub-pixel is h₃, and a distance between the center of the other first sub-pixel and the center of the third sub-pixel is h₂, where h₁>h₃; and
in one first virtual quadrilateral, a distance between the center of one first sub-pixel and the center of the third sub-pixel is h₄, and a distance between the center of the other first sub-pixel and the center of the third sub-pixel is h₂, where h₃>h₄.

34. The display panel according to claim 32, wherein
the third virtual quadrilateral is an irregular quadrilateral, and the second virtual quadrilateral inside the third virtual quadrilateral is a square; and
the four first virtual quadrilaterals at the position of the third virtual quadrilateral are irregular quadrilaterals.

35. The display panel according to claim 32, wherein
the elliptical-arc orientation of the first sub-pixel on the third virtual quadrilateral is parallel to or perpendicular to a first direction;
among the four first virtual quadrilaterals:
in two first virtual quadrilaterals, a distance between the center of one first sub-pixel and the center of the third sub-pixel is h₅, and a distance between the center of the other first sub-pixel and the center of the third sub-pixel is h₆; and
in the other two first virtual quadrilaterals, a distance between the center of one first sub-pixel and the center of the third sub-pixel is h₇, and a distance between the center of the other first sub-pixel and the center of the third sub-pixel is h₆, where h₅>h₇.

36. The display panel according to claim 14, wherein
there are four first virtual quadrilaterals at a position of the third virtual quadrilateral; and
in each of the four first virtual quadrilaterals, centers of the second sub-pixels are equidistant from a center of the third sub-pixels.

37. The display panel according to claim 14, further comprising a fourth virtual quadrilateral, wherein four second sub-pixels form the fourth virtual quadrilateral; one second virtual quadrilateral is positioned inside the fourth virtual quadrilateral, and one second sub-pixel is positioned inside the second virtual quadrilateral; and the four second sub-pixels forming the fourth virtual quadrilateral are irregularly-shaped sub-pixels; and
the elliptical-arc orientations of two second sub-pixels positioned at opposite corners of the fourth virtual quadrilateral are perpendicular to or parallel to each other.

38. The display panel according to claim 37, wherein
on the third virtual quadrilateral, the elliptical-arc orientations of two adjacent first sub-pixels in a first direction are different from each other, and the elliptical-arc orientations of two adjacent first sub-pixels in a second direction are different from each other; and the first direction intersects the second direction; and/or
on the fourth virtual quadrilateral, the elliptical-arc orientations of two adjacent second sub-pixels in the first direction are different from each other, and the elliptical-arc orientations of two adjacent second sub-pixels in the second direction are different from each other.

39. The display panel according to claim 37, wherein
the first sub-pixel inside the third virtual quadrilateral is the irregularly-shaped sub-pixel, and the elliptical-arc orientation of the first sub-pixel is different from the elliptical-arc orientations of the first sub-pixels on the third virtual quadrilateral; or a shape contour of the first sub-pixel positioned inside the third virtual quadrilateral is circular; and/or
the second sub-pixel inside the fourth virtual quadrilateral is the irregularly-shaped sub-pixel, and the elliptical-arc orientation of the second sub-pixel is different from the elliptical-arc orientations of the second sub-pixels on the fourth virtual quadrilateral; or a shape contour of the second sub-pixel positioned inside the fourth virtual quadrilateral is circular.

40. The display panel according to claim 1, wherein
the third sub-pixels forming the second virtual quadrilateral are irregularly-shaped sub-pixels.

41. The display panel according to claim 40, wherein
in the irregularly-shaped sub-pixel, a direction from the circular arc to the elliptical arc is an elliptical-arc orientation; on the second virtual quadrilateral, the elliptical-arc orientations of the four third sub-pixels are different from each other, and the elliptical-arc orientations of two third sub-pixels positioned at opposite corners of the second virtual quadrilateral are opposite to each other.

42. The display panel according to claim 40, wherein
the first virtual quadrilateral is a square, and the second virtual quadrilateral is a parallelogram.

43. The display panel according to claim 1, comprising a substrate and a pixel definition layer positioned on one side of the substrate, wherein the pixel definition layer comprises a plurality of openings, and each sub-pixel comprises one opening; and the plurality of openings comprise a first opening, and the irregularly-shaped sub-pixel comprises the first opening;
the sub-pixel comprises a light-emitting layer, at least a portion of the light-emitting layer is positioned within the first opening, and a pattern area of the light-emitting layer is larger than an area of the first opening; and
in the irregularly-shaped sub-pixel, a pattern of the light-emitting layer is a rectangle or a circle, and a center of the pattern of the light-emitting layer is non-coincident with a center of the first opening.

44. The display panel according to claim 1, wherein
the third sub-pixel is a green sub-pixel, one of the first sub-pixel and the second sub-pixel is a red sub-pixel, and the other of the first sub-pixel and the second sub-pixel is a blue sub-pixel.

45. The display panel according to claim 1, comprising a substrate, a light-blocking structure, and a plurality of color light-filtering units;
wherein the light-blocking structure is positioned on one side of the sub-pixels away from the substrate; the light-blocking structure comprises a plurality of hollows, and along a direction perpendicular to a plane of the substrate, the hollow at least partially overlaps the irregularly-shaped sub-pixel; and the color light-filtering unit is at least partially positioned within the hollow.

46. The display panel according to claim 1, comprising a substrate, a light-blocking structure, and a reflection control layer;
wherein the light-blocking structure is positioned on one side of the sub-pixels away from the substrate; the light-blocking structure comprises a plurality of hollows, and along a direction perpendicular to a plane of the substrate, the hollow at least partially overlaps the sub-pixel; and
the reflection control layer is positioned on one side of the light-blocking structure away from the substrate, and at least partially positioned within the hollow.

47. The display panel according to claim 1, comprising a substrate and a supporting post, wherein an orthographic projection of the supporting post onto the substrate is located between an orthographic projection of the first sub-pixel onto the substrate and an orthographic projection of the second sub-pixel onto the substrate; and the first sub-pixel is the irregularly-shaped sub-pixel;
the supporting post comprises a first supporting post and a second supporting post, an orthographic projection of the first supporting post onto the substrate is adjacent to an orthographic projection of the circular arc of the irregularly-shaped sub-pixel onto the substrate, and an orthographic projection of the second supporting post onto the substrate is adjacent to an orthographic projection of the elliptical arc of the irregularly-shaped sub-pixel onto the substrate; and
wherein along a direction parallel to a plane of the substrate, a distance between the first supporting post and the irregularly-shaped sub-pixel is equal to a distance between the first supporting post and the second sub-pixel, and a distance between the second supporting post and the irregularly-shaped sub-pixel is smaller than the distance between the first supporting post and the irregularly-shaped sub-pixel.

48. The display panel according to claim 1, comprising a substrate and a light sensor, wherein the light sensor is disposed in at least one display region of the display panel; an orthographic projection of the light sensor onto the substrate is located between orthographic projections of adjacent first sub-pixel and second sub-pixel onto the substrate; and the first sub-pixel is the irregularly-shaped sub-pixel;
the light sensor comprises a first light sensor and a second light sensor, an orthographic projection of the first light sensor onto the substrate is adjacent to an orthographic projection of the circular arc of the irregularly-shaped sub-pixel onto the substrate, and an orthographic projection of the second light sensor onto the substrate is adjacent to an orthographic projection of the elliptical arc of the irregularly-shaped sub-pixel onto the substrate; and
wherein along a direction parallel to a plane of the substrate, a distance between the first light sensor and the irregularly-shaped sub-pixel is equal to a distance between the first light sensor and the second sub-pixel, and a distance between the second light sensor and the irregularly-shaped sub-pixel is smaller than the distance between the first light sensor and the irregularly-shaped sub-pixel.

49. The display panel according to claim 48, wherein
the orthographic projection of the light sensor onto the substrate is located between orthographic projections of the first sub-pixel and the second sub-pixel adjacent in a second direction onto the substrate, and the second direction is parallel to the plane of the substrate;
the first sub-pixel as well as one second sub-pixel and one third sub-pixel adjacent thereto form one pixel, the first sub-pixel is shared by two pixels, the second sub-pixel is shared by two pixels, and the third sub-pixel is not shared by pixels; and
in the display region provided with the light sensor, a ratio of a number of pixels to a number of light sensors is 1:1.

50. A display apparatus, comprising the display panel according to any one of claims 1 to 49.
